# EUROPEAN PATENT SPECIFICATION

(11) **EP 1 646 083 B1**
(45) Date of publication and mention of the grant of the patent: **31.08.2016**
(21) Application number: 05447167.7
(22) Date of filing: 08.07.2005
(51) Int. Cl.: H01L 21/768, H01L 21/311

(54) **Alternative dual damascene patterning approach**
Alternatives Doppeldamaszen-Strukturierungsverfahren
Procédé alternatif de double damasquinage

(30) Priority: 08.10.2004 US 617555; 11.04.2005 US 669973
(43) Date of publication of application: 12.04.2006
(73) Proprietor: IMEC, 3001 Leuven (BE)
(72) Inventor: Van Olmen, Jan, 3370 Boutersem (BE); Van Hove, Marleen, 3052 Blanden (BE); Struyf, Herbert, 2550 Kontich (BE); Hendrickx, Dirk, 3040 Sint-Agatha-Rode (BE); Vanhaelemeersch, Serge, 3001 Leuven (BE); Boullart, Werner, 3001 Leuven (BE)
(74) Representative: Van Malderen, Joëlle

(56) References cited:
- US-A1- 2004 084 412
- US-B1- 6 323 123
- US-B1- 6 365 529
- US-B1- 6 372 616
- US-B1- 6 607 675
- US-B1- 6 689 695
- POSSEME ET AL.: "Etching Mechanisms of Low-k SiCOH and Selectivity to SiCH and SiO2 in Fluorocarbon Based Plasmas" J. VAC.SCI.TECHNOL. B, vol. 21, no. 6, November 2003 (2003-11), pages 2432-2440, XP002358927
- TSANG C F ET AL: "Study and improvement of electrical performance of 130 nm Cu/CVD low k SiOCH interconnect related to via etch process" MICROELECTRONICS JOURNAL, MACKINTOSH PUBLICATIONS LTD. LUTON, GB, vol. 34, no. 11, November 2003 (2003-11), pages 1051-1058, XP004469757 ISSN: 0026-2692

## Description

### FIELD OF INVENTION

The present invention is related to the field of patterning dual damascene interconnect structures. The present invention is further characterized in eliminating photoresist poisoning and avoiding, or at' least minimizing, low-k damage during patterning.

### BACKGROUND

The semiconductor industry is continuously reducing the dimensions of the devices. In Back End of Line (BEOL) processing it concerns the reducing dimensions of conductive layers as well as the separation of the different conductive structures to each other. Lowering the capacitance in between these structures becomes extremely important and low-k materials replace conventional dielectric insulating materials. The use of these (porous) low-k materials as dielectric materials in interconnect structures brings new issues to the semiconductor processing. Examples of these issues include photoresist poisoning and low-k damage due to etch, ash and/or clean processes.

Photoresist poisoning is a particular problem when 248 nm (DUV) or 193 nm (ArF) wavelength photoresists are used in conjunction with porous low-k materials. The presence of traces of base nitrogen containing compounds such as amines may neutralize the acids generated upon exposure of 248 nm or 193 nm photoresist and thus inhibiting the chemically amplified acid reaction what is referred to as photoresist poisoning. The altered photoresist material may not be lithographically patterned as expected and result in imprecisely formed features in the photoresist material or excessive photoresist residue remaining on the substrate surface after photoresist development, both of which can detrimentally affect subsequent processes, such as etching processes.

Amines, may originate directly from deposited materials adjacent to the resist layer. Amines can also contaminate indirectly the resist material, such as by diffusion through one or more layers, outgassing of materials during processing steps (such as annealing and plasma treatment) and by etching processes which may expose underlying nitrogen containing layers (such as silicon nitride etch stop layers) to any subsequently deposited resist materials.

Other materials that may also result in resist poisoning include base compounds containing hydroxyl groups.

With the via-first approach for dual damascene patterning, the use of photoresist layers on dielectric layers often results in "poisoning" of the line imaging resist which is done after vias are fully or partially etched into the dielectric.

The poisoning is probably due to absorption and/or generation and liberation of amine compounds from the insulator, as a result of its finite permeability and the use of N₂ and H₂ process gases in the films below, as well as in the etching and stripping of patterns prior to applying the photoresist where the poisoning is observed. The poisoning problem appears to be much worse when the dielectric layer is a porous low-k insulator applied using chemical vapor deposition (CVD), as compared to silicate glass dielectric layers. This is thought to be a result of the increased permeability of low-k insulators, the use of N₂O as a carrier gas in some deposition recipes, and the common use of reducing chemistries such as N₂ and H₂ for stripping prior lithographic patterns.

Another important issue in integrating low-k dielectrics is the plasma damage caused by etching, stripping and post etch cleaning. The plasma species that are diffused into the low-k film may change the composition of the film and its structure. The use of oxygen containing etch/strip chemistries typically results in depletion of the carbon present in the film, making the film hydrophilic and susceptible to water (k value » 80) adsorption, which leads to an increase of the k-value of the film. This problem is becoming even more important with the miniaturization of IC's where the feature size becomes comparable to the damaged region.

Several approaches are described in the state of the art to solve the poisoning problems but these are incomplete and too complicated.

One attempt is to use a resist material that is less sensitive to poisoning. However, such resist materials compromise imaging resolution and decrease lithographic process window.

Another attempt is to modify the dielectric material so that it causes less poisoning. For example, in U.S. Pat. No. 6, 147, 009 to Grill et al., the use of N₂O as an oxidizing carrier gas is avoided by using a siloxane-based precursor and He gas to make low-k SiCO(H) films, thereby eliminating a source of nitrogen, in the as-deposited film. This may prevent poisoning of a first photoresist material on the blanket SiCO(H) film, but after the pattern is etched into the SiCO (H) film and the resist is stripped, amines may still be generated and may poison a subsequent photoresist patterning step such as would be required for dual damascene interconnects.

Another method is to eliminate poisoning of photoresist by pre-treating the low-k material with e.g. acidic compounds. In US 2002/0081855 an in-situ plasma treatment is disclosed which immediately removes the source of poisoning by reducing or eliminating poisoning at trench patterning level. However, such modifications may adversely affect the dielectric constant and other characteristics of the insulating materials.

Another approach with partial success is to deposit a barrier material after via etch. In this approach, the via is lined with a very thin layer of a barrier material such as TEOS or silane SiO₂, thereby encapsulating the poisoning source. The liner material must have excellent conformality. Since it is difficult to deposit materials in high-aspect ratio vias, this approach may not be expendable to future technologies. Defects in thin regions of this liner may allow poisoning gases to pass through, and even with low statistical occurrence may cause an unacceptable level of defective patterns in the line imaging layer. An example of this approach is described in US 6,645,864.

In US 6,713,386 by Hu et al. the low-k material is exposed after via etch to a plasma containing gas components such as oxygen, carbon dioxide, ozone or hydrogen peroxide such that a protective layer is formed on the surface of the low-k material which neutralizes nitrogen. This is however not without the risk of damaging the low-k material and increasing the k-value of the bulk low-k material.

Another approach for preventing resist poisoning during patterning is described in US 2004/127016. The use of a dual cap layer is disclosed. The dual cap layer is formed over the low-k insulator layer prior to the etching of a via or trench toward an underlying conductor. The dual cap layer includes a layer of silicon carbide and a layer of silicon nitride. The silicon carbide layer maintains the critical dimension of the via or trench as it is etched through the insulating layer, while the silicon nitride layer inhibits the failure mechanism of resist poisoning. This approach is only valid for single damascene processing and not applicable for etching a trench over a patterned via structure with the via-first approach in dual damascene processing.

US 2004/0087164 by Bao et al. discloses the use of an I-line or deep UV photoresist as barrier layer for use in the via-first approach for dual damascene patterning. The barrier layer is deposited on the low-k material after via etching. The resist used as barrier layer comprises hydroxy groups that can attract nitrogen containing compounds. Prior to the deposition of the barrier layer an inert polymeric resin can be deposited in the via to close the via or optionally the spin-coated barrier layer can be used to fill the via and form a coplanar layer on the damascene stack. A trench is etched within the via structure with an oxide etchant (plasma) which consumes the photoresist and BARC layers and consumes a portion of the barrier layer and resin layer. In the case of CVD low-k materials, this oxidizing plasma will cause low-k damage to the sidewalls of the trenches. After trench etching there is still a considerable amount of barrier layer and resin layer that needs to be removed by means of a wet stripping process (oxidizing solution containing H₂SO₄/H₂O₂) which involves a further risk of low-k damage.

US 2004/0266201 by Wille et al. discloses an alternative method making use of a barrier layer for use in the via-first approach for dual damascene patterning. A barrier layer is deposited on the upper surface of the low-k material after via etching. A planarizing material is also here deposited to fill the via prior to the barrier layer deposition. The trench etching in the low-k material is performed by means of an O₂ comprising plasma which introduces low-k damage if the low-k material is a SiCO(H) material (also called CVD low-k material). The barrier layer is removed during the trench etching. The remaining part of the planarizing material in the bottom part of the via still needs to be removed (strip) by means of an O₂ comprising strip chemistry which introduces again damage to the sidewalls of the trenches.

US 6, 372, 616 discloses a method of manufacturing an electrical interconnection in which a contact hole is formed in the interlayer dielectric layer, and the contact hole is filled with an erosion protecting plug of an organic material most of which remains in the contact hole until a recess for accommodating a conductive line is formed in the interlayer dielectric layer.

N Posseme et al. ("Etching Mechanisms of Low-% SiOCH and Selectivity to SiCH and SiO2 in Fluorocarbon Based Plasmas" J.VAC.SCI.TECHNOL. B, vol.21; n°6,, November 2003, pages 2432-2440) disclose an analysis of the etch mechanisms of SiOCH, SiO₂ and SiCH in fluorocarbon plasmas.

US 6,607,675 discloses a method for plasma etching a carbon-containing silicon oxide film which comprises exposing the film to a plasma generated from a source gas comprising NH₃ and CₓF_{y}.

Thus, the prior art proposes several solutions for eliminating resist poisoning but all of them do have serious drawbacks and shortcomings. The prior art does never provide a solution that simultaneously solves the problem of eliminating (photoresist poisoning and avoiding or at least minimizing plasma damage of the dielectric material. On the contrary, some of the prior art solutions to avoid photoresist poisoning create low-k damage.

### SUMMARY

The present invention provides a method for patterning a dual damascene structure used in semiconductor processing.

More particularly, the present invention provides a metal hardmask based patterning method, which allows to eliminate resist poisoning while avoiding (or at least minimizing) low-k damage.

A method according to the invention can be used to eliminate photoresist poisoning in dual damascene patterning, in particular to eliminate or reduce the photoresist poisoning for trench etching over a via as performed in a via-first approach, while avoiding or at least minimizing plasma damage to the sidewalls, in particular the sidewalls of the trenches in the via-first approach used for dual damascene patterning.

A method according to the invention comprises the steps of:
- depositing a dielectric layer on a substrate, said substrate preferably comprising a patterned structure,
- optionally depositing a capping layer on said dielectric layer,
- etching a first hole in said capping layer and said dielectric layer,
- depositing a gap filling material such that said first hole is completely filled,
- removing part of the gap filling material such that its level equals the level of said dielectric layer or the level of said capping layer,
- depositing a metal hardmask layer on said dielectric layer or if present, on said capping layer,
- depositing imaging material(s) on said hardmask layer,
- forming at least one first pattern in said imaging material(s),
- transferring the pattern in said hardmask layer (or opening said hardmask),
- removing said imaging material(s),
- removing said gap filling material, and
- etching a second hole over said first hole in said dielectric layers.

The dielectric material is preferably a low-k dielectric material and more preferably a porous CVD low-k material, for example (hydrogenated) silicon-oxy-carbide materials (SiCO(H)) such as ®Black Diamond and ®Aurora. (SiCO (H)) .

The gap filling material (which can also be referred to as planarizing material) is preferably an organic material, for example, a commonly used BARC (Bottom Anti-Reflective Coating) material, the underlayer (UL) of the TIS2000® bilayer (Fujifilm Electronic Materials), SiLK®, polyarylsulfones, polyhydroxystyrene based derivatives, polyimides, polyethers (in particular polyarylene ethers e.g. FLARE® from Honeywell and VELOX® from Schumacher), polyarylenesulfides, polycarbonates, epoxies, epoxyacrylates, polyarylenes (such as polyphenylenes), polyarylenevinylenes (such as polyphenylenevinylenes), polyvinylcarbazole, cyclic olefins, and/or polyesters, etc.

The hardmask layer deposited on the surface of the dielectric material or on the capping layer is a metal hardmask layer such as TaN, TiN, Ta, TaSiN, TiSiN, TiW and/or WN layer(s), which acts as a barrier layer preventing migration of amine compounds through the low-k material towards upperlaying imaging layer(s) (e.g. photoresist layer(s)).

The first problem of avoiding resist poisoning is thus solved by means of a barrier layer; preferably said barrier layer is a hardmask layer and more preferably is a metal hardmask layer.

In a method of the invention, said imaging material(s) preferably comprise(s) at least one photoresist layer and optionally at least one anti-reflective coating layer (e.g. BARC).

In a preferred embodiment, the removal of part of the gap filling material is achieved by etching back said gap filling layer such that its level equals the level of the capping layer (i.e. both gap filling and capping layer levels are aligned). If there is no capping layer, its level is aligned on the top of the dielectric layer.

Said etching can be an isotropical or anisotropical dry-etch process.

In a method of the invention, the removal of part of the gap filling material can also be achieved by chemical mechanical polishing said planarizing layer, wherein the capping layer is used as stop layer such that the (level of the) gap filling material equals the level of the capping layer. And if there is no capping layer, its level is aligned on the top of the dielectric layer.

To solve the second problem of sidewalls damage, the dielectric material is anisotropically etched using a dry etch plasma that is an oxygen free plasma.

Preferably, the oxygen free plasma used in the anisotropically dry-etch process is selective towards the (metal) hardmask layer.

The second hole can thus be etched over the first hole by means of an anisotropically dry-etch process wherein the plasma is oxygen free and is preferably selective towards said hardmask layer.

More particularly, in a via-first approach, a trench can thus be etched over a via by means of an anisotropically dry-etch process wherein the plasma is oxygen free and is preferably selective towards said hardmask layer.

The anisotropical etching chemistry used for etching said second hole in said dielectric layer presents the advantage of avoiding or at least minimizing plasma damage to the sidewalls of the hole in the dielectric material.

In a method according to the invention, the removal of the imaging material(s) can be performed prior to or after the removal of the gap filling material.

Preferably, in a method according to the invention, the removal (strip) of the imaging material(s) and the removal of the gap filling material are performed simultaneously or in other words in one single step.

In a method of the invention, the removal of the imaging material(s) can be performed prior to the etching of the second hole or simultaneously (in one single step).

In a method according to the invention, wherein said etching of said second hole is performed in a (distinct) separate step, said oxygen free plasma further contains fluorocarbon compounds (CₓH_{y}F_{z} compounds) (such as CHF₃, CH₃F, CH₂F₂, CF₄, C₂F₆, C₄F₈, C₅F₈ etc) and nitrogen. Preferably, said oxygen free plasma comprises C₄F₈ and nitrogen.

Said etch plasma may further contain inert compounds such as argon, etc.

Alternatively and also preferably, the step of removing the imaging layer(s) and the step of etching a second hole (or more specifically of etching a trench in a via-first-approach) in the dielectric layer are performed simultaneously (i.e. in one single step) by means of an anisotropical etching process using said oxygen free plasma.

When the removal of the imaging material(s) and the etching of said second hole are performed simultaneously (i.e. in one single step), said oxygen-free plasma is a hydrogen containing plasma.

Said oxygen free plasma may further contain fluorocarbon compounds (CₓH_{y}F_{z} compounds) (such as CHF₃, CH₃F, CH₂F₂, CF₄, C₂F₆, C₄F₈, C₅F₈ etc).

Preferably, said hydrogen containing plasma comprises CF₄.

Preferably, CF₄ is in a small amount. For example, the CF₄ flow is comprised between (about) 0,1% and

(about) 1% of the total flow, preferably between (about) 0,2% and (about) 0,7% of the total flow. Preferably, the CF₄ flow is (about) 0,5% of the total flow. ,

Said oxygen-free, hydrogen containing plasma may further comprise nitrogen.

More preferably, in a method according to the invention, the step of etching the second hole in the dielectric material and the step of removing both the imaging layer(s) and the gap filling material are performed simultaneously (i.e. in one single step).

In other words, the same oxygen free plasmacan be used for stripping the photosensitive layer (s), for removing the gap filling material and for etching the second hole.

In such a method, the oxygen free plasma is an hydrogen comprising plasma, which may further comprise fluorocarbon compounds (CₓH_{y}F_{z} compounds), more particularly CF₄.

Preferably, a method according to the invention further comprises the step of depositing a dielectric barrier layer upon said substrate, before the step of depositing said dielectric layer.

Said dielectric barrier layer can act as an etch stop layer and can also act as copper barrier layer.

A method of the invention may further comprise the step of depositing a copper barrier layer and optionally a copper seed layer onto the sidewalls of the via and trench.

A method of the invention may further,comprise the step of depositing copper within the trench and via and the step of removing the overburden of copper, copper barrier layer, copper seed layer (if any) and remaining (metal) hardmask layer, which are underneath said overburden of copper, by means of chemical mechanical polishing.

A method according to the invention can be used in a full-via-first process (first-via approach) for forming a dual damascene interconnect structure on a patterned structure.

In the context of the invention, the substrate is preferably a semiconductor substrate comprising a patterned structure.

Said patterned structure is preferably a single damascene interconnect structure.

Said single damascene interconnect structure is preferably a copper containing structure patterned in a dielectric layer.

Preferably, before the step of depositing said dielectric layer, a dielectric barrier layer is deposited upon said substrate (or upon said patterned structure).

Alternatively, a method of the invention can be used in a partial-via-first approach for forming a dual damascene interconnect structure.

In a partial-via-first method, said dual damascene interconnect structure is formed upon a patterned structure.

In a partial-via-first method of the invention, a second dielectric barrier layer can be deposited upon said dielectric layer and a second dielectric layer can be deposited upon said second dielectric barrier layer (before the optional step of depositing said capping layer) .

In a via-first approach or in a partial via-first approach, the first hole corresponds to a via and the second hole, etched over the first one, corresponds to a trench.

### BRIEF DESCRIPTION OF THE DRAWINGS

All drawings are intended to illustrate some aspects and embodiments of the present invention. Devices are depicted in a simplified way for reason of clarity. Not all alternatives and options are shown and therefore the invention is not limited to the content of the given drawings. Like numerals are employed to reference like parts in the different figures.
Figures 1A to 1L illustrate the method for patterning a dual damascene structure using the different processing steps of the present invention based on a via first approach.

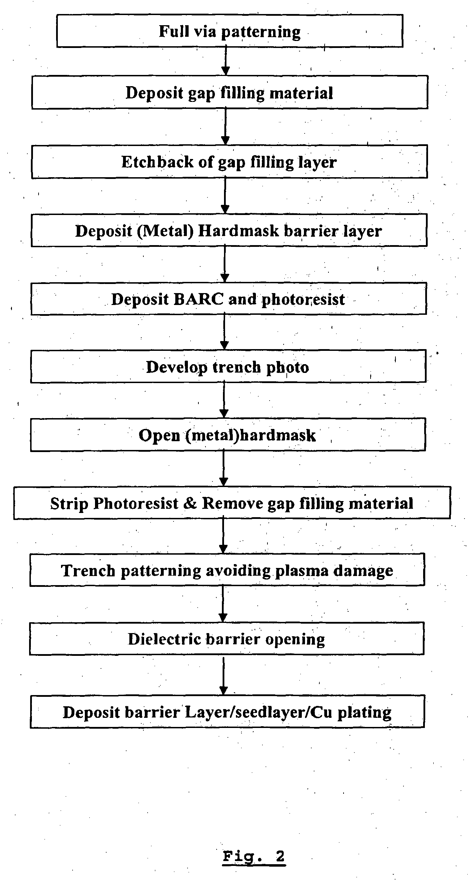

Figure 2 is a flowchart representing the different processing steps of a preferred embodiment of the present invention.

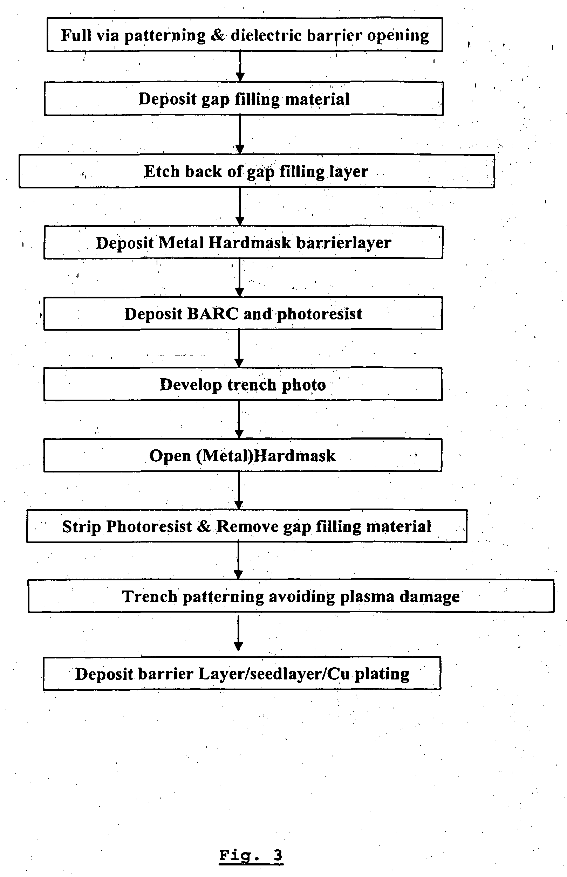

Figure 3 is an alternative flowchart representing the different processing steps of another preferred embodiment of the present invention. The opening of the SiC layer at the bottom of the via is opened here before the patterning of the trench.
Figure 4 is an alternative flowchart representing the different processing steps of another preferred embodiment of the present invention. The gap filling material is planarized by means of chemical mechanical polishing.
Figure 5 is an alternative flowchart representing the different processing steps of another preferred embodiment of the present invention. The photoresist is stripped before the removal of the gap filling material in the via.
Figure 6 is an alternative flowchart representing the different processing steps of another preferred embodiment of the present invention. The photoresist and trench patterning are performed simultaneously.
Figures 7A to 7M illustrate the method for patterning a dual damascene structure using the different processing steps of the present invention based on a partial-via-first approach with intermediate dielectric barrier.
Figures 8A to 8I illustrate the method for patterning a single damascene structure eliminating photoresist poisoning and minimizing low-k damage.
Figure 9 is a flowchart representing the different processing steps of a preferred embodiment of the present invention for patterning a single damascene structure eliminating photoresist poisoning and minimizing low-k damage.
Figure 10 is an alternative flowchart representing the different processing steps for patterning a single damascene structure eliminating photoresist poisoning and minimizing low-k damage.
Figure 11 illustrates a cross-section SEM showing filling of 100 nm size vias etched in a SiOC material after filling with 400 nm UL.
Figure 12 illustrates a tilted top-view of the planarized vias after the UL etchback step.
Figure 13 shows a top-view SEM picture after trench (second hole) photolithographic patterning.
Figure 14 shows that good Metal 2 - Via alignment was obtained without metal clear-out.
Figure 15 shows a cross-section SEM photo after metal-hard-mask opening and strip.
Figure 16 shows a top-view SEM picture after full dual damascene patterning of the present invention.

### DETAILED DESCRIPTION OF THE INVENTION

The following description illustrates an alternative method for patterning a (dual) damascene structure thereby at least eliminating photoresist poisoning and additionally avoiding or at least minimizing plasma damage of the dielectric material. It will be appreciated that there are numerous variations and modifications possible.

For a dual damascene patterning, the invention is based on using a combination of first depositing a gap filling material (in a via) and a (metal) hardmask to eliminate photoresist poisoning to solve the first problem and second performing a dry-etch process selective towards said (metal) hardmask such that the second problem of plasma damage to the dielectric material is avoided or at least minimized during patterning of a (dual) damascene structure.

For a single damascene patterning, the invention is based on first depositing a (metal) hardmask onto the dielectric material,prior to the patterning to eliminate photoresist poisoning and second performing a dry-etch process selective towards said (metal) hardmask such that plasma damage to the dielectric material is avoided or at least minimized during patterning of the single damascene structure (trench).

It should be noted here that the via-first and the trench-first sequences are the processes currently being used in mainstream production for patterning of dual damascene structures.

In the via-first approach the vias are defined first in the ILD (Inter Level Dielectric or Inter Layer Dielectric used to electrically separate closely spaced interconnect lines), followed by patterning the trenches.

The sequence of forming the damascene structure in this approach begins by exposing the via patterns with the first mask. After etching the vias completely through the entire dielectric stack and stripping the resist, a second mask is used to pattern the trenches.

The invention is focused on at least eliminating photoresist poisoning for trench patterning over the via and avoiding or at least minimizing plasma damage to the dielectric material during trench etching.

More specifically the trench etching is optimized such that damage to the sidewalls of the trenches is minimized.

A method for patterning a dual damascene structure used in semiconductor processing is disclosed.

The patterning is further characterized as a metal hardmask based patterning eliminating resist poisoning and avoiding or at least minimizing low-k damage.

The method is used to eliminate photoresist poisoning in dual damascene patterning and in reducing the photoresist poisoning for trench etching over a via as performed in a via-first approach.

The method is further characterized in avoiding or at least minimizing plasma damage to the sidewalls of the trenches in the via-first approach used for dual damascene patterning.

A hardmask layer, more preferably a metal hardmask layer such as TaN or TiN is deposited on the surface of the dielectric material as barrier layer to prevent migration of amine compounds through the low-k material towards upperlaying photosensitive imaging layer(s) (e.g. photoresist layer(s)).

The first problem of avoiding resist poisoning is thus solved by means of a barrier layer, preferably said barrier layer is hardmask layer and most preferred a metal hardmask layer.

The trenches are etched over a via (via-first approach) by means of an anisotropically dry-etch process that is selective towards said hardmask layer.

To solve the second problem of sidewall damage the dry etch plasma used for anisotropically etch the dielectric material is selective towards the (metal) hardmask layer and is an oxygen free plasma.

Performing the removal of the photosensitive layers and gap filling materials prior to or simultaneously with the etching of the trenches avoids also further damage to the dielectric materials, more specifically to the sidewalls of the trenches. The problem of exposure of the sidewalls of the trenches to the strip chemistry comprising oxygen is thus avoided.

The method comprises the steps of depositing a dielectric layer on a semiconductor substrate; depositing a capping layer on said dielectric layer; etching a first hole (via) in said capping layer and dielectric layer, depositing a gap filling material such that at least a complete filling of the hole is achieved; removing part of the gap filling material such that it equals the level of the capping layer; depositing a hardmask layer; depositing imaging material(s) on said hardmask layer; forming at least one first pattern in the layers of imaging material(s), transfer the pattern in the hardmask layer and removing the imaging material(s) and gap filing material; etching a second hole (trench) in the dielectric layer.

Finally a copper barrier layer and optionally a copper seed layer are deposited onto the sidewalls of the via and trench. Finally copper is deposited within the trench and via and the overburden of copper, copper barrier and remaining (metal) hardmask layer are removed by means of chemical mechanical polishing.

Preferably the removal of the imaging material(s) and the removal of the gap filling material are performed simultaneously or in other words in the same step. Alternatively the removal of the imaging material(s) is performed prior to the removal of the gap filling material.

In another preferred sequence, the method of etching the second hole in the dielectric material and removal of the imaging material(s) and/or gap filling material are performed simultaneously or in other words in the same step.

The dielectric material is preferably a low-k dielectric material and more preferably a porous CVD low-k material (e.g. SiCO(H)). The planarizing material is preferably an organic gap filling material. The hardmask layer is preferably a metal hardmask layer.

The method may further comprise the steps of depositing a layer of anti-reflective coating (BARC) prior to the deposition of (an) imaging material(s).

In a preferred embodiment, the removal of part of the gap filling material is achieved by etching back said gap filling layer such that it equals the level of the capping layer. Said etching can be an isotropical or anisotropical dry-etch process.

In another preferred embodiment, the removal of part of the gap filling material is achieved by chemical mechanical polishing said planarizing layer wherein the capping layer is used as stop layer such that the gap filling material equals the level of the capping layer.

In a preferred embodiment, the invention involves a full-via-first method for forming a dual damascene interconnect structure on a semiconductor substrate comprising at least one patterned conductor.

Alternatively, a method of the invention is disclosed for forming a dual damascene interconnect structure using a partial-via-first approach.

The partial-via-first method preferably makes use of an intermediate dielectric barrier.

The method of the invention is also applied for forming a single damascene interconnect structure.

The invention is further characterized in the fact that the etching of the trench in the dielectric material is selective towards the hardmask layer. Most preferred said hardmask layer, is a metal hardmask and the dielectric material is a CVD type low-k material.

Preferably the anisotropical etching chemistry for etching a second hole (trench) in the dielectric layer is characterized as an etch chemistry avoiding or at least minimizing plasma damage to the sidewalls of the trench. In a preferred process flow the removal of the imaging material(s) is performed prior to the etching of the second hole (trench) and the etch chemistry is an oxygen free plasma. The etch chemistry of this etch process preferably avoids or at least minimizes plasma damage to the dielectric material. The plasma is an oxygen-free plasma containing CₓH_{y}F_{z} compounds (fluorocarbon compounds), more preferred the CₓH_{y}F_{z} compound is C₄F₈. The etch plasma further contains nitrogen and may contain inert compounds such as argon, etc.

Alternatively and also preferred the anisotropical etching chemistry for etching a second hole or more specific for etching a trench in the dielectric layer is characterized as an etch chemistry minimizing plasma damage to the sidewalls of the trench whereby the removal of the imaging material(s) is performed simultaneously to the etching of the second hole (trench) and the etch chemistry is an oxygen free plasma. The etch plasma is further characterized as an hydrogen comprising plasma, more specifically this plasma is a hydrogen and optionally CₓF_{y} comprising plasma without using oxygen thereby minimizing plasma damage to the low-k material.

### Dual Damascene patterning method based on full-Via-first approach.

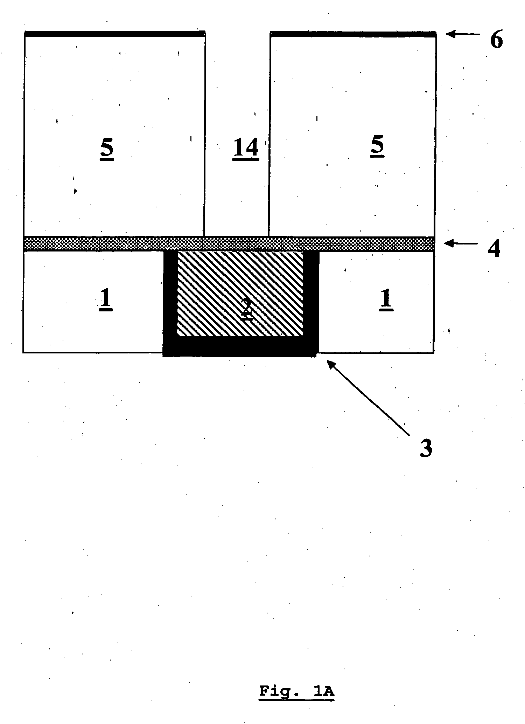

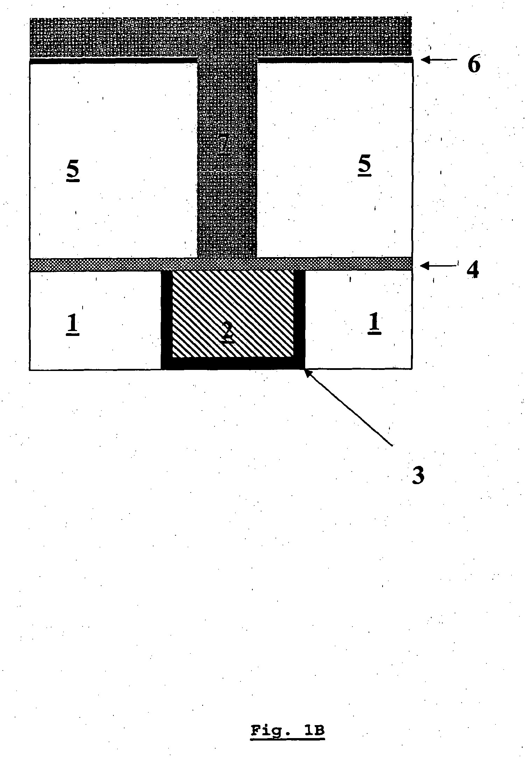

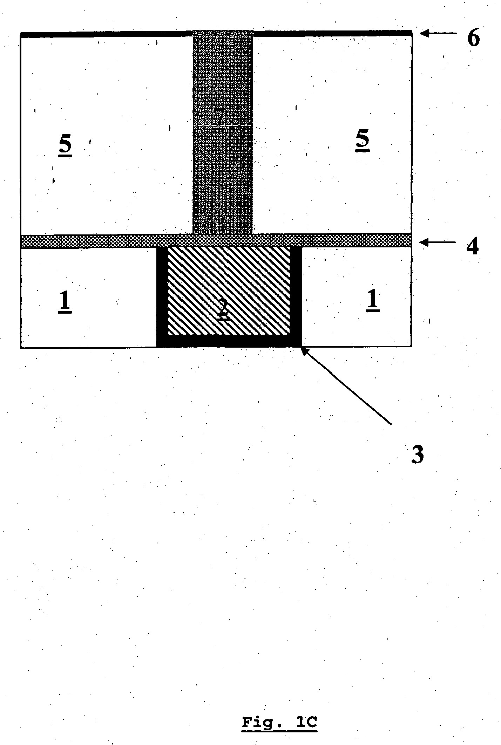

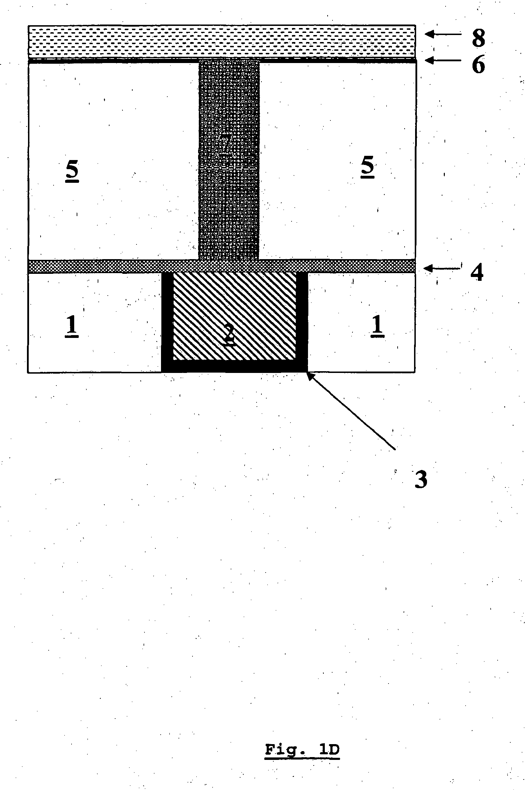

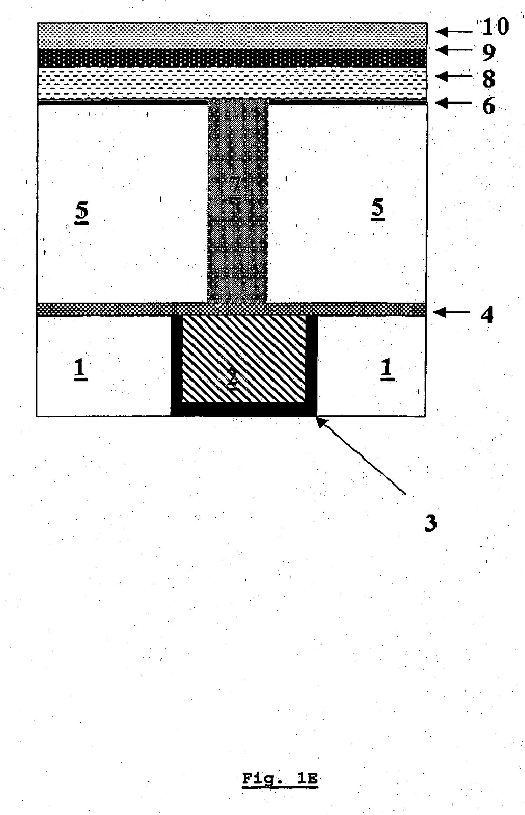

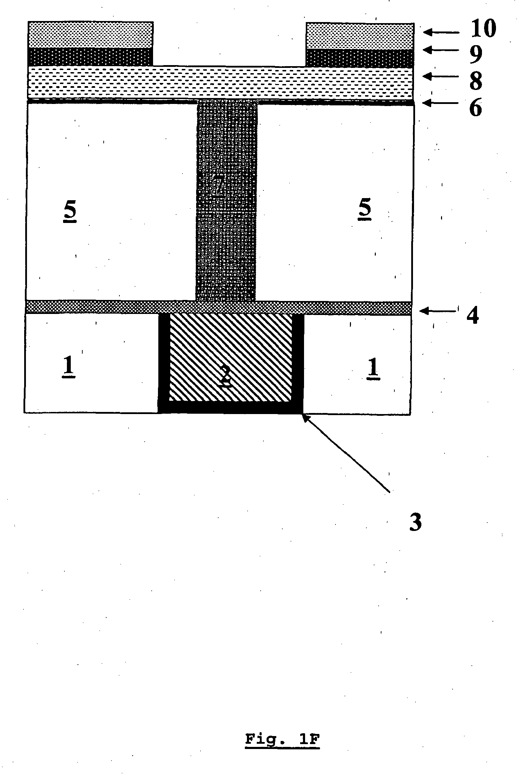

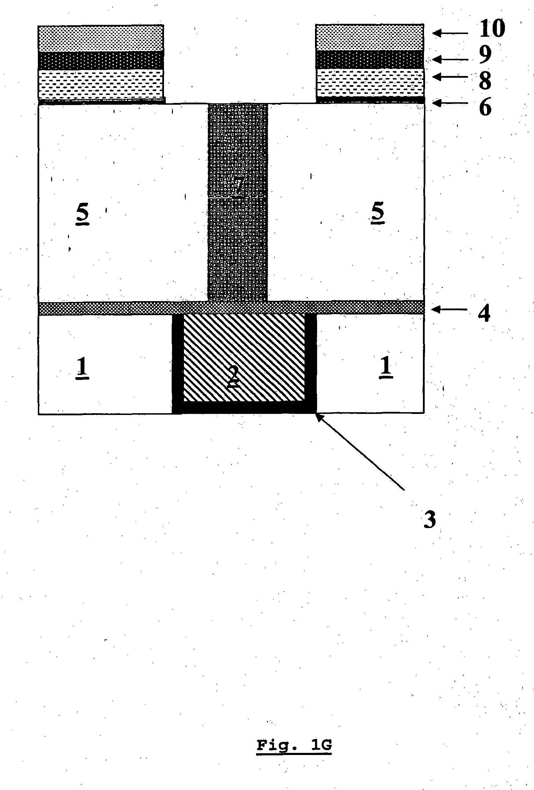

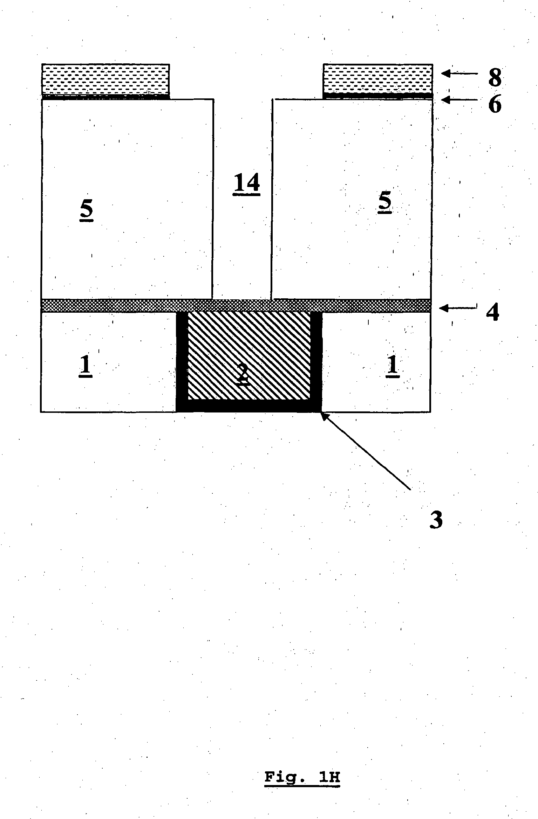

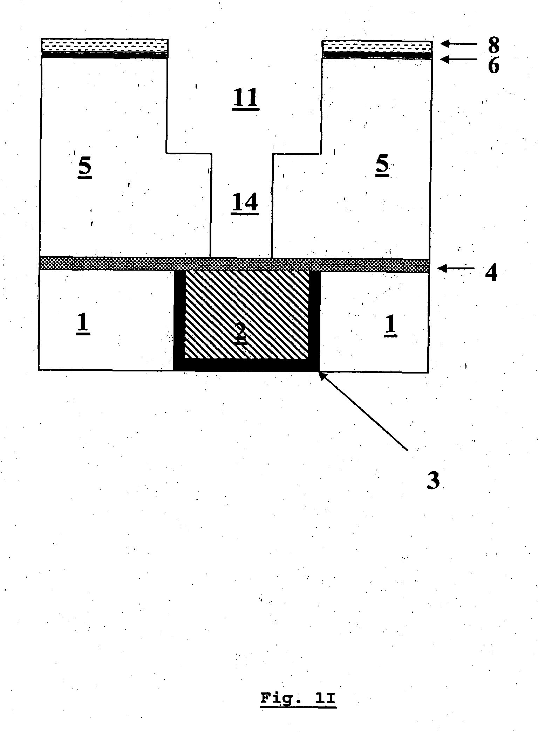

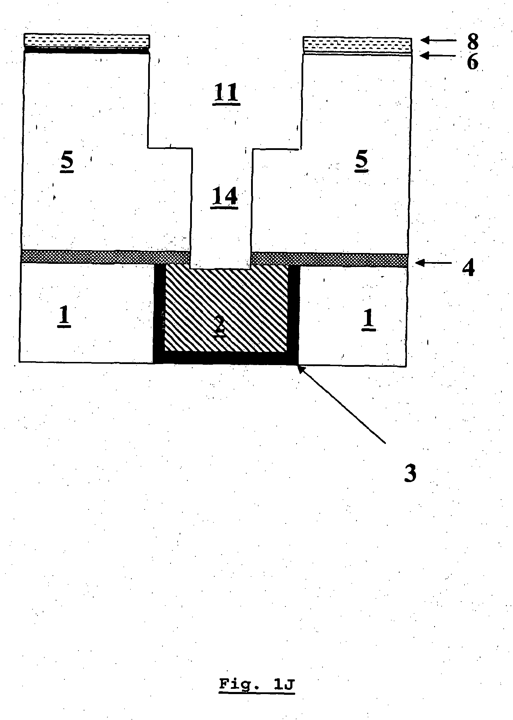

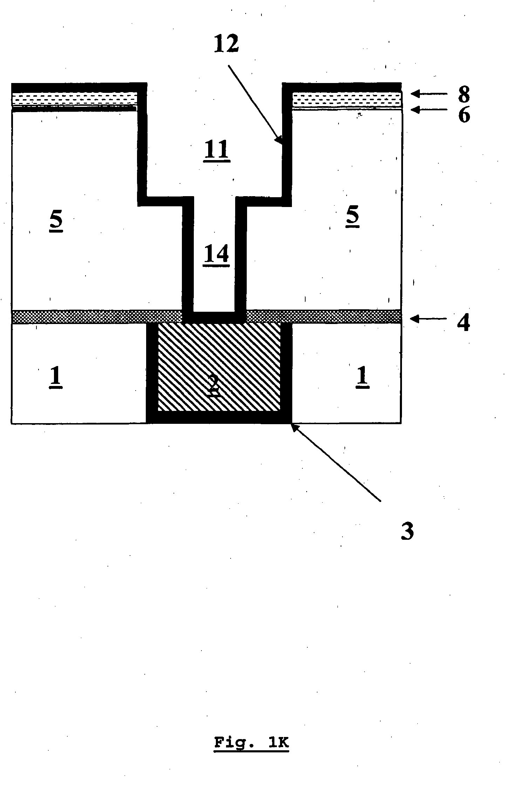

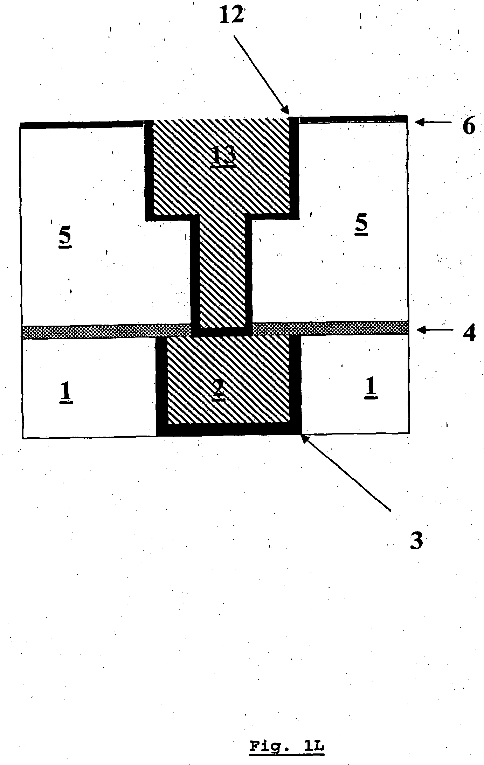

The method of the present invention for patterning of a (dual) damascene structure based on the full-via-first approach will be described in detail. The method is characterized in eliminating photoresist poisoning during trench patterning. The method is further characterized in avoiding or at least minimizing plasma damage to the dielectric material during trench etching. The method is schematically presented in Figures 1A to 1L and will now be described in detail.

Preferably the starting point is a semiconductor substrate comprising a patterned structure, preferably said patterned structure is a single damascene interconnect structure, further referred to as first trench or Metal 1.

Said patterned structure comprises a copper structure **2** patterned in a dielectric material **1,** a copper diffusion barrier layer **3.**

The dielectric material **1** is preferably a low-k material and more preferably a silicon containing low-k material. Examples of these silicon containing low-k materials are CVD (Chemical Vapor Deposition) type low-k materials such as (hydrogenated) silicon-oxy-carbide materials (SiCO(H)) such as ^{®}Black Diamond and ^{®}Aurora.

Preferably a dielectric barrier **4** is deposited upon said substrate (or upon said patterned structure).

Preferably said dielectric barrier **4** is a SiC(N) layer, which can be used as an etch stop layer in further processing steps. Other examples of dielectric barriers include TEOS oxide, silane oxide and Si₃N₄.

A layer of dielectric material **5** is then deposited on said substrate (or upon said patterned structure).

Preferably the dielectric material 5 is a low-k material and more preferably a CVD low-k material. Examples of these CVD low-k materials are commercially available materials such as ^{®}Black Diamond, ^{®}Aurora, etc.

Dielectric layers **1** and **5** 'are preferably of the same materials.

An optional capping layer **6** is deposited above the dielectric layer **5.** This capping layer may be formed of SiC(N), nitride- or oxide-type materials such as TEOS-oxide, silane-oxide.

Then a hole **14,** more specifically a via hole, is formed in the dielectric layer 5 by using conventional patterning techniques making use of photolithography followed by an anisotropic dry etch process to transfer the pattern in the photoresist layer to the capping layer **6** (if any) and dielectric layer **5** (not shown).

The dielectric barrier layer **4** can be used as an etch stop layer during the anisotropic dry etching.

A conventional strip process combined with cleaning (to make sure that no residues are left) removes the remaining photoresist.

A gap filling material 7 is then deposited in the via hole such that at least a complete filling of the hole (via) is achieved.

Preferably the gap filling material 7 is an organic spin-on material. Examples of such materials are the underlayer (UL) of the TIS2000^{®} bilayer (Fujifilm Electronic Materials), SiLK^{®}, polyarylsulfones, polyhydroxystyrene based derivatives, polyimides, polyethers (in particular polyarylene ethers e.g. FLARE^{®} from Honeywell and VELOX^{®} from Schumacher), polyarylenesulfides, polycarbonates, epoxies, epoxyacrylates, polyarylenes (such as polyphenylenes), polyarylenevinylenes (such as polyphenylenevinylenes), polyvinylcarbazole, cyclicolefins, polyesters, etc.

The overburden of the gap filling material 7 is then removed such that its level equals the level of the capping layer 6. If there is no capping layer, its level is then aligned on the top of the dielectric layer 5.

The removal of the gap filling material 7 is preferably done by a dry-etch process, also referred to as "etchback".

Subsequently a diffusion barrier layer **8** to eliminate photoresist poisoning in further processing is deposited.

The diffusion barrier layer **8** of the present invention is a hardmask layer, more preferred a metal hardmask layer. Examples of these metal hardmask layers are TaN, TiN, Ta, TaSiN, TiSiN, TiW and WN.

Imaging material(s) is (are) then deposited and a pattern to define the trench over the via is transferred to the imaging material(s).

The imaging material(s) can consist of at least one photoresist layer **10** and optionally of at least one anti-reflective coating **9** (e.g. a Bottom Anti-Reflective Coating or BARC).

Preferably said imaging materials consist of at least one photoresist layer **10** and of at least one anti-reflective coating **9** (e.g. a Bottom Anti-Reflective Coating or BARC).

After the hardmask layer **8,** and possibly also the capping layer **6,** are opened, the imaging material(s) (photoresist layer(s) **10** and if any anti-reflective coating **9),** and gap filling material **7** are removed by means of a stripping process.

The stripping process can be e.g. by means of a SF₆/O₂ dry strip plasma.

Preferably the removal (strip) of imaging material(s) (photoresist layer(s) **10** and if any anti-reflective coating **9)** and gap filling material **7** in the via are performed simultaneously.

Complete removal of the gap filling material and imaging material(s) prior to the dry etching of the trench over the via avoids a first cause of possible sidewall damage of the trenches.

To etch the second opening **11** or "trench" in the dielectric material an anisotropic etch process which is selective towards the hardmask is used.

More specifically an etch process is used that is selective towards a metal hardmask layer.

The etch chemistry of this etch process is further characterized such that it avoids plasma damage to the dielectric material. Preferably this plasma is an oxygen-free plasma containing fluorocarbon compounds (CₓH_{y}F_{z} compounds), more preferred the CₓH_{y}F_{z} compound is C₄F₈.

The etch plasma can further contain nitrogen and may contain inert compounds such as argon, etc.

A Cu diffusion barrier layer **12** is deposited in the trench and via openings to avoid migration of copper in the surrounding dielectric (low-k). Common used copper diffusion barrier layers **12** such as Ta(N), Ti (N), WNC, etc., can be used here.

Subsequently the trench and via hole is electroplated with copper **13.**

The remaining part of the (metal) hardmask layer, the overburden of copper and overburden of copper diffusion barrier layer is then removed by means of conventional chemical mechanical polishing.

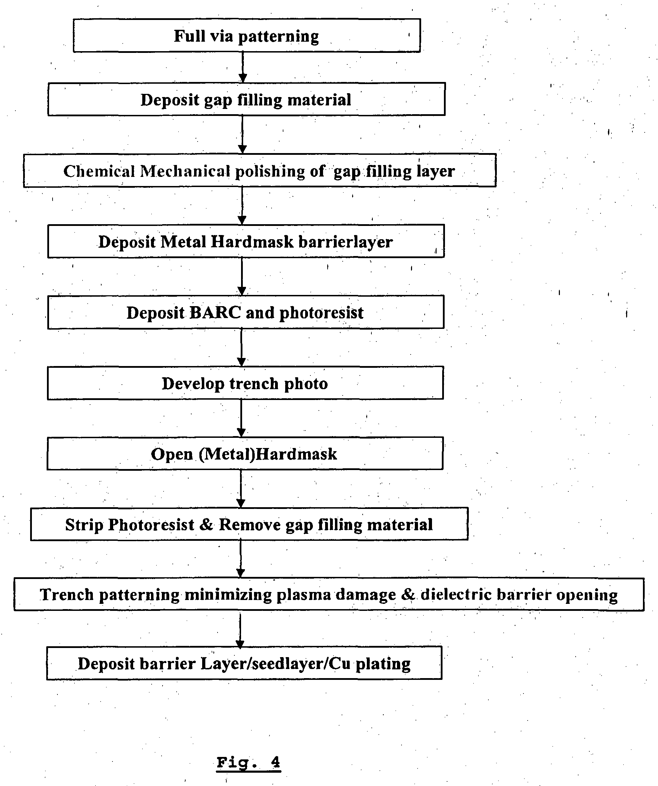

Alternatively to the method described above and also preferred, the overburden of the gap filling material **7** is removed such that it equals the level of the capping layer **6** by means of Chemical Mechanical Polishing (CMP). This alternative process flow is schematically shown in Figure **4****.**

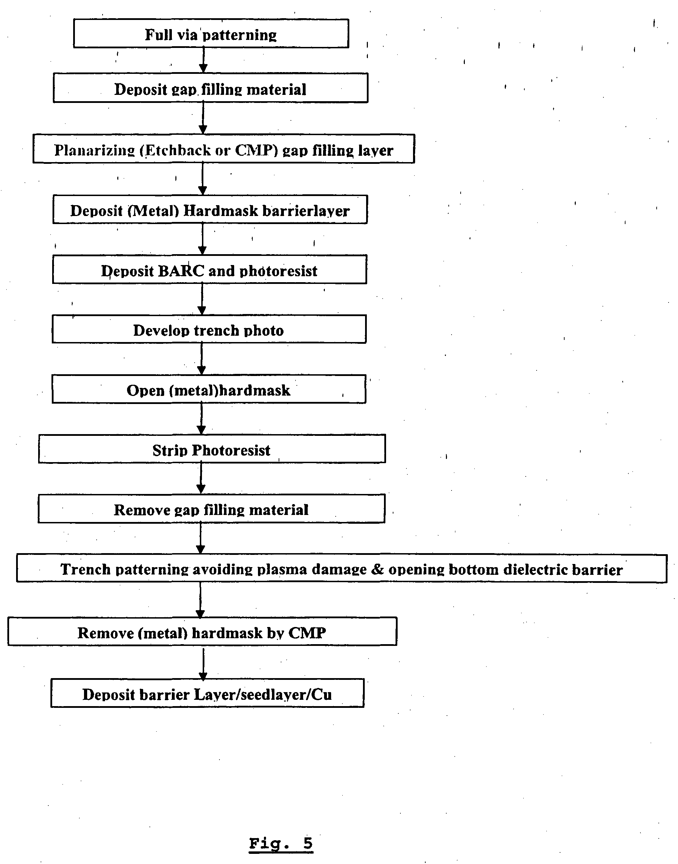

Alternatively to the method described above and also preferred, the removal (strip) of the imaging material(s) **(10** and if any **9,** respectively photoresist and BARC layers) is performed prior to the removal of the gap filling material **7.** This alternative process flow is schematically shown in Figure 5.

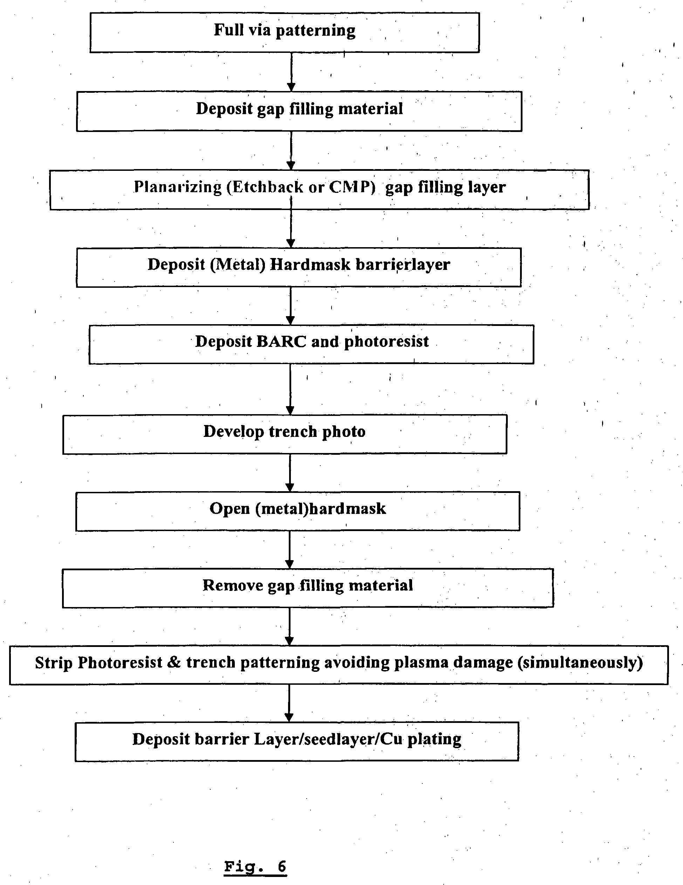

Alternatively to the method described above and also preferred, the etching of the second opening or "trench" in the dielectric material and removal of imaging material(s) **(10** and if any **9)** are performed simultaneously. The anisotropic etch process used to perform this trench etching is also selective towards the (metal) hardmask used. The etch chemistry of this etch process is further characterized such that it minimizes plasma damage to the dielectric material. Preferably this plasma is an oxygen-free plasma containing hydrogen. Other compounds such as inert compounds may be added to this plasma. Preferably small amounts of CₓF_{y} compounds are added to this plasma, most preferred this CₓF_{y} compound is CF₄ and most preferred said concentration of CF₄ is 5sccm. This alternative process flow is schematically shown in Figure 6. The removal of the gap filling material **7** in this process flow can be performed before or during the anisotropical dry-etch process for trench etching.

### Dual Damascene patterning method based on partial-via-first approach

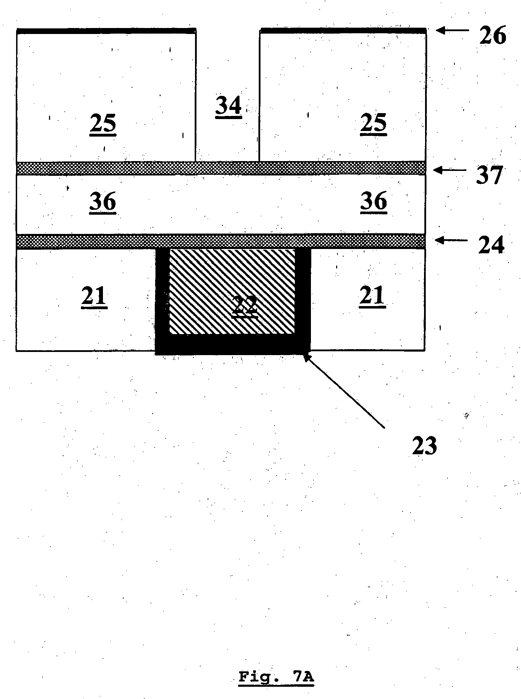

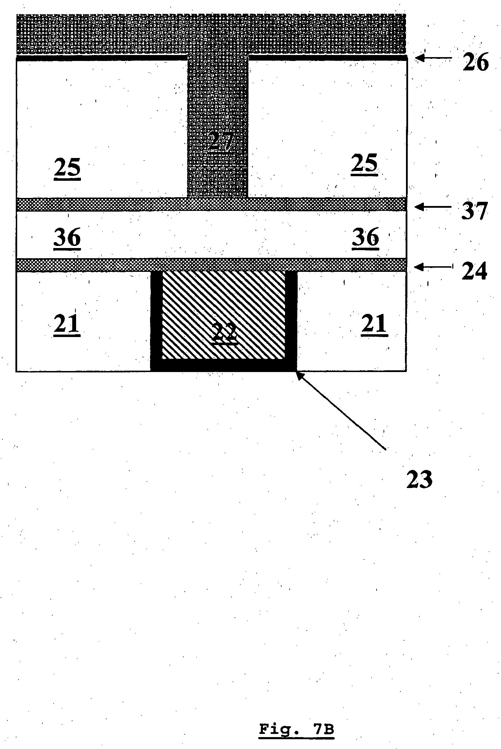

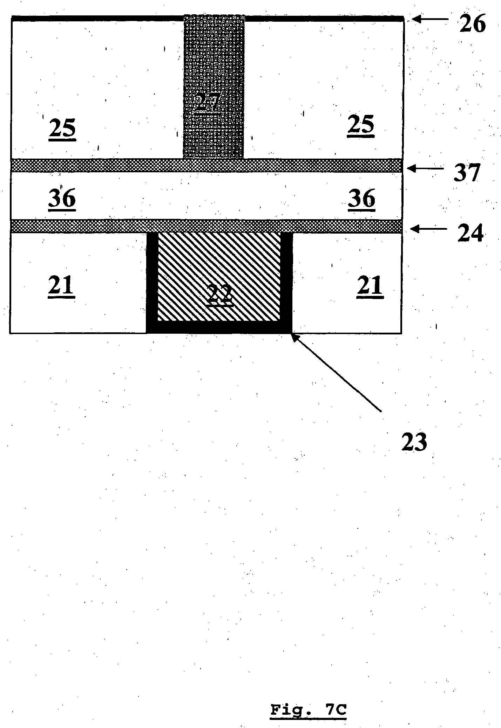

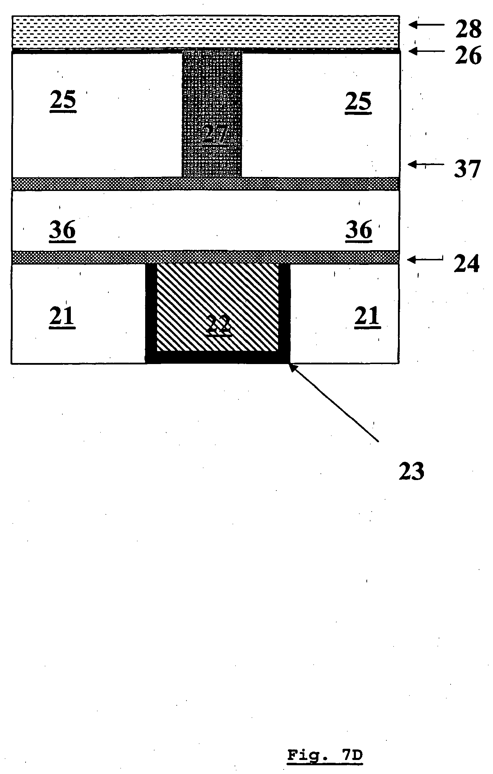

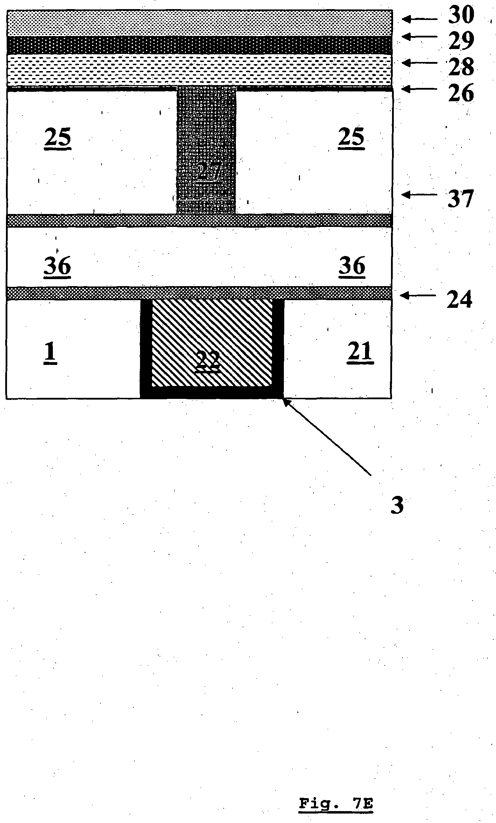

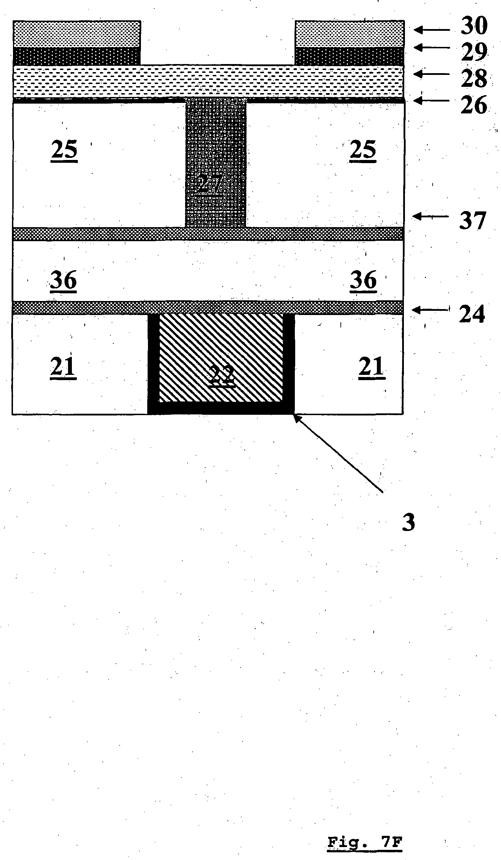

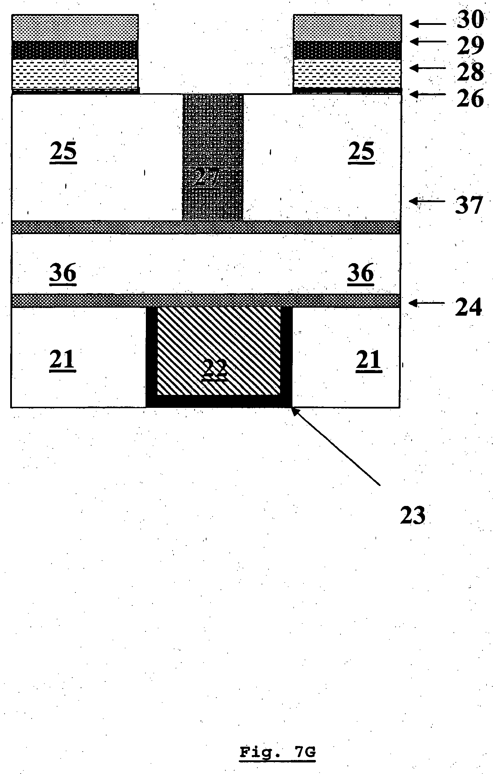

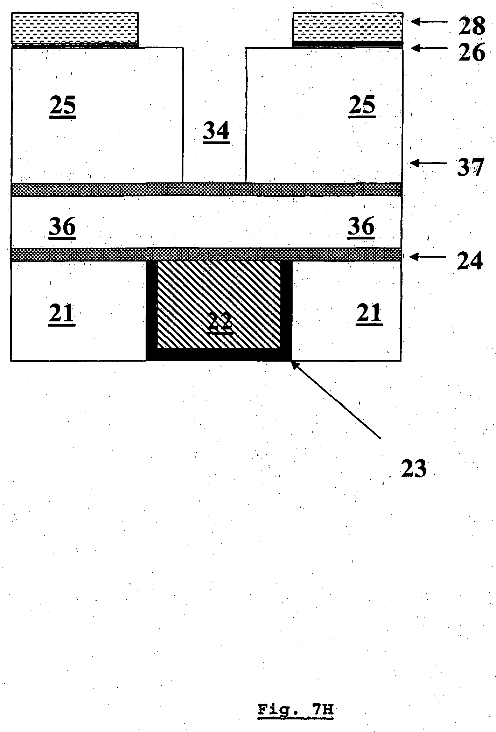

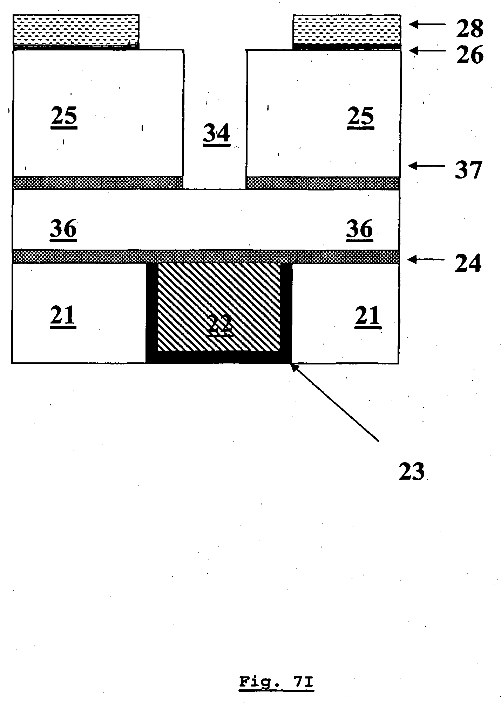

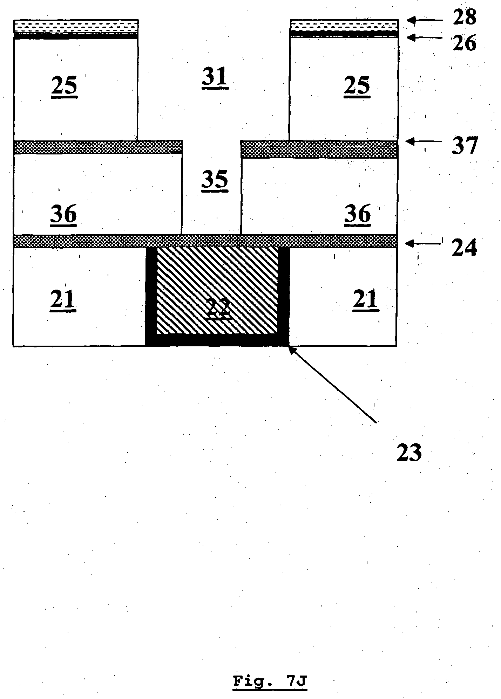

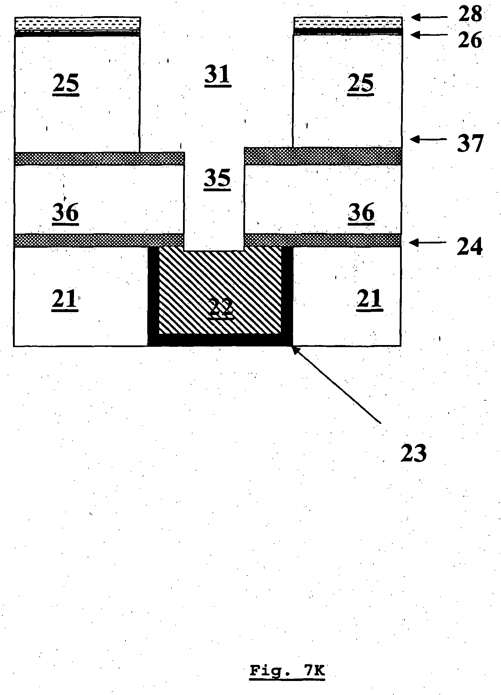

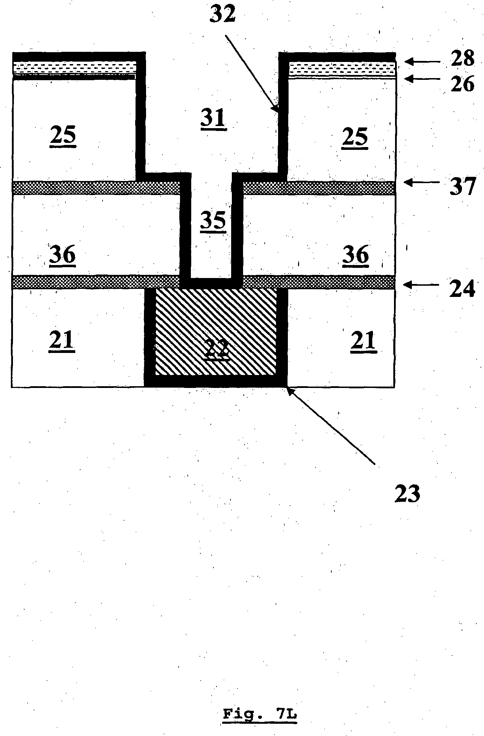

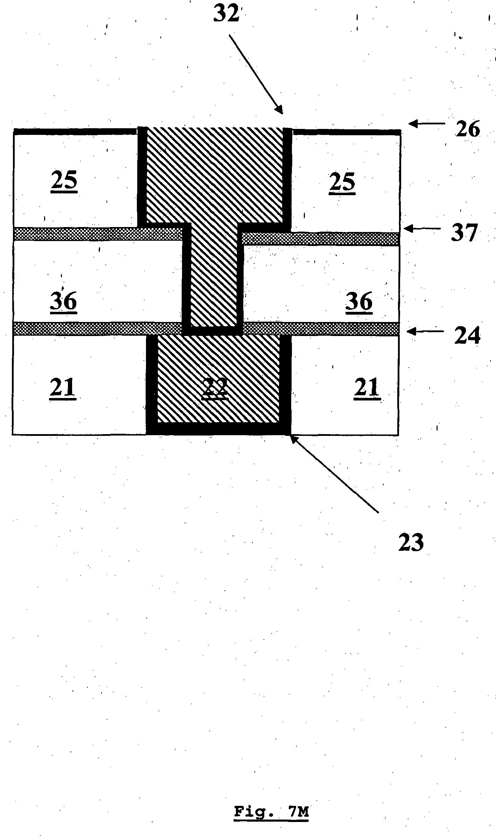

Alternatively to the full-via-first approach, a method based on the present invention for patterning of a dual damascene structure based on a partial-via-first approach is also disclosed and will be described below and illustrated in Figures 7A-7M. The method is characterized in eliminating photoresist poisoning during trench patterning. The method is further characterized in avoiding or at least minimizing plasma damage to the dielectric material during trench etching (and remaining part of the via).

Preferably the starting point is a substrate comprising a patterned structure.

Said patterned structure comprises a copper pattern **22** or structure such as trenches that are developed in the dielectric layer **21.**

The dielectric material **21** is preferably a low-k material and more preferably a silicon containing low-k material. Examples of these silicon containing low-k materials are CVD (Chemical Vapor Deposition) type low-k material such as (hydrogenated) silicon-oxy-carbide materials (SiCO(H)) such as ^{®}Black Diamond and ^{®}Aurora.

The patterned structure is preferably a single damascene structure, also referred to as Metal 1.

A stack of layers comprising at least one dielectric etchstop layer **24** (also referred to as dielectric barrier layer) and at least one layer of dielectric material 25 are then deposited on said substrate.

Preferably the dielectric etchstop layer **24 is** a SiC(N) layer, to be used as an etch stop layer in further processing steps. Other examples of dielectric etchstop layers include TEOS oxide, silane oxide and Si₃N₄.

Preferably the dielectric material **25** is a low-k material and more preferably a CVD low-k material. Examples of these CVD low-k materials are commercially available materials such as ^{®}Black Diamond, ^{®}Aurora, etc.

As presented on Figures 7A-7M, the stack of layers preferably further comprises a layer of dielectric material **36** (also referred to as embedded dielectric layer **36)** deposited on said dielectric etchstop layer **24,** and a second dielectric barrier **37,** also referred to as intermediate dielectric barrier layer **37,** deposited on said embedded dielectric layer **36.**

Said dielectric layer **25** is then deposited on the intermediate dielectric barrier layer **37.**

Dielectric material **25** and embedded dielectric material **36** are preferably the same materials.

An optional capping layer **26** can be deposited above dielectric layer **25,** this capping layer may be formed of oxide-type materials such as TEOS-oxide and silane-oxide or nitride-type materials such as SiC(N).

Then a hole, more specifically a "partial" via hole **34,** is formed in dielectric layer **25** by using conventional patterning techniques making use of photolithography followed by an anisotropic dry etch process to transfer the pattern in the photoresist layer to the capping **layer 26 and** dielectric layer **25 (not** shown).

The intermediate dielectric barrier layer 37 is used as an etch stop layer during the anisotropic dry etching to create a "partial" via hole **34.**

A conventional strip process combined with (wet) cleaning to make sure that no residues are left is then used to remove remaining photoresist and etching residues.

A gap filling material **27** is then deposited in the partial via hole **34** such that at least a complete filling of the hole is achieved.

Preferably the gap filling material **27** is an organic spin-on material such as a common used BARC (Bottom Anti-Reflective Coating) material, etc (as described earlier).

The overburden of the gap filling material **27** is then removed such that its level equals the level of the capping layer **26.**

The removal of the overburden of the gap filling material **27** is preferably done by a dry-etch process, also referred to as "etchback".

Subsequently a diffusion barrier layer **28** to eliminate photoresist poisoning in further processing is deposited. The diffusion barrier layer **28** of the present invention is a hardmask layer, more preferred a metal hardmask layer. Examples of these metal hardmask layers are TaN, TiN, Ta, TaSiN, TiSiN, TiW and WN.

Imaging material(s) or photosensitive layer(s) (photoresist layer(s) **30** and if any anti-reflective coating **29)** are then deposited and a pattern to define the trench over the via is transferred to the imaging material(s).

The imaging material(s) can consist of at least one photoresist layer **30** and optionally of at least one anti-reflective coating **29** (e.g. a Bottom Anti-Reflective Coating or BARC). Preferably, said imaging materials consist of at least one photoresist layer 30 and of at least one anti-reflective coating **29** (e.g. a Bottom Anti-Reflective Coating or BARC).

After the hardmask layer **28** and, possibly also the capping layer **26** are opened, the imaging material(s) and gap filling material **27** are removed by means of a stripping.

The stripping process can be e.g. by means of a SF₆/O₂ dry strip plasma.

Preferably the removal (strip) of imaging material(s) (photoresist layer(s) **30** and if any anti-reflective coating **29)** and gap filling material **27** in the via are performed simultaneously.

Complete removal of the gap filling material 27 and imaging material (s) prior to the dry etching of the trench over the via avoids a first cause of possible sidewall damage of the trench.

To etch the second opening **31** or "trench" in the dielectric material **25** an anisotropic etch process which is selective towards the hardmask is used and preferably the intermediate dielectric barrier layer **37** is used as etch stop layer.

Simultaneously with the trench etching the partial via is further patterned such that a complete via is obtained making use of the dielectric etchstop layer **24** as etch stop layer for the via.

The dry-etch process used to pattern the trench **31** in dielectric layer **25** and to pattern a complete via **35** in the embedded dielectric layer **36** is further characterized as a selective etching process towards a metal hardmask layer **28.**

The etch chemistry of this etch process is further characterized such that it avoids or at least minimizes plasma damage to the dielectric material **25.**

Preferably this plasma is an oxygen-free plasma containing fluorocarbon compounds (CₓH_{y}F_{z} compounds), more preferred the CₓH_{y}F_{z} compound is C₄F₈.

The etch plasma further contains nitrogen and may contain inert compounds such as argon, etc.

A Cu diffusion barrier layer is deposited in the trench and via opening to avoid migration of copper in the surrounding dielectric (low-k).

Common used copper diffusion barrier layers such as Ta(N), Ti(N), WNC, etc., can be used here.

Subsequently the trench **31** and via **35** is electroplated with copper.
The overburden of copper, overburden of copper diffusion barrier layer and remaining part of the (metal) hardmask layer 28 is then removed by means of chemical mechanical polishing.

Alternatively to the method described above and also preferred, the overburden of the gap filling material 27 is removed such that its level equals the level of the capping layer 26 by means of Chemical Mechanical Polishing (CMP).

Alternatively to the method described above and also preferred, the removal (strip) of the imaging layer(s) (photoresist and if any BARC) is performed prior to the removal of the gap filling material (depending on type and composition of gap filling material).

Alternatively to the method described above and also preferred, the etching of the second opening or trench 31 in the dielectric material 25 (etching the complete via 35 included) and removal of imaging material(s) (layer(s) 30 and if any 29, referred to as photoresist and BARC) are performed simultaneously. The anisotropic etch process used to perform this trench etching is also selective towards the (metal) hardmask used. The etch chemistry of this etch process is further characterized such that it reduces plasma damage to the dielectric material. Preferably this plasma is an oxygen-free plasma containing hydrogen. Other compounds such as inert compounds can be added to this plasma. Preferably, said inert compound is nitrogen. Preferably fluorocarbon compounds (CₓF_{y} compounds) are added to the plasma. More preferably, said CₓF_{y} compound is CF₄. Preferably, CF₄ is added at a concentration of (about) 5 sccm.

The removal of the gap filling material 27 in this process flow can be performed simultaneously or before the anisotropical dry-etch process for trench etching depending on the material properties of this gap filling material.

Alternatively to the methods described above and also preferred, the etching of the second opening or trench 31 in the dielectric material 25 is a time-etch process instead of an etch process stopping on an etch stop layer. In that case there is no need for an embedded dielectric layer **36** and no need for an intermediate etch stop layer **37** (or second dielectric barrier layer).

### Single Damascene patterning method eliminating photoresist poisoning and minimizing plasma damage (not part of the present claimed invention).

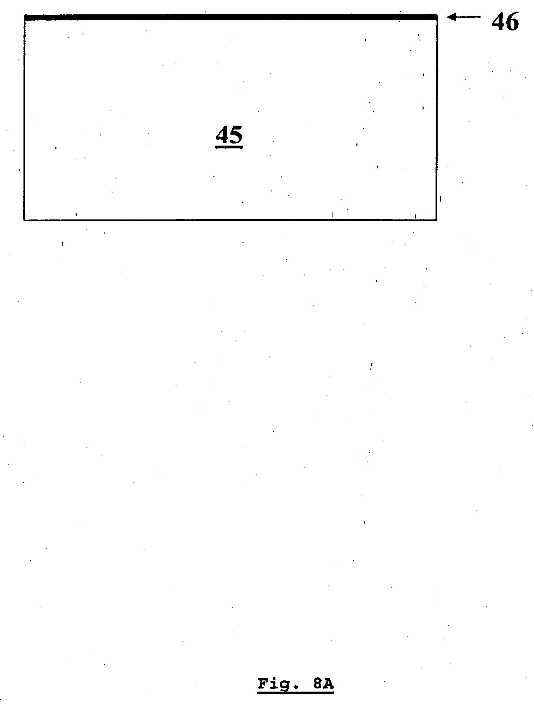

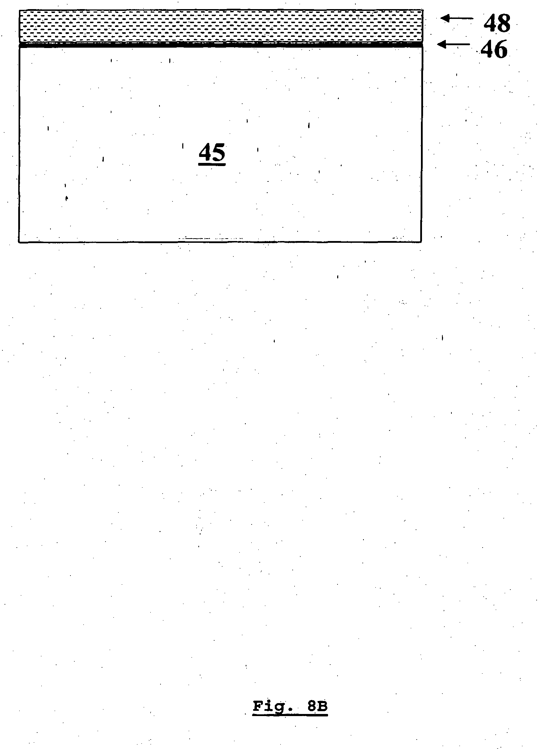

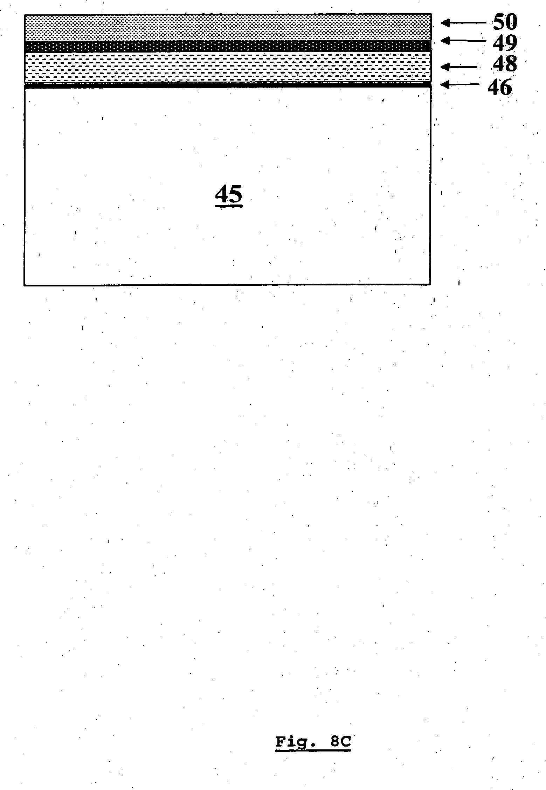

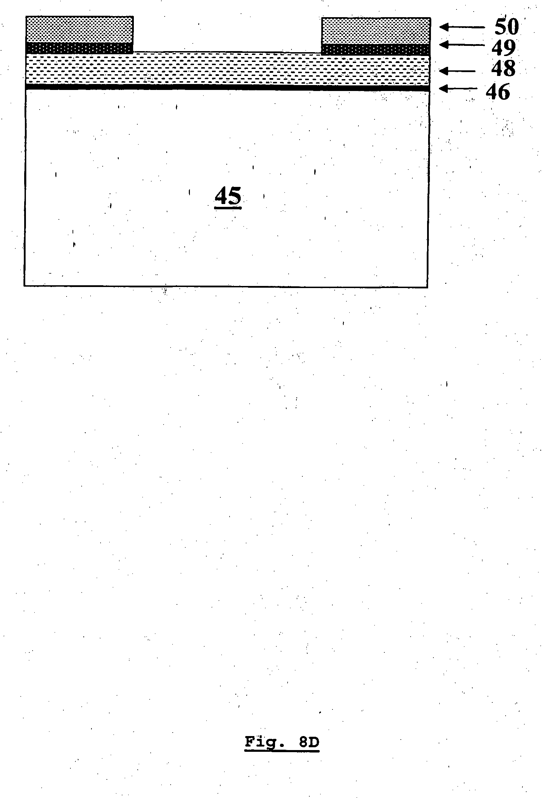

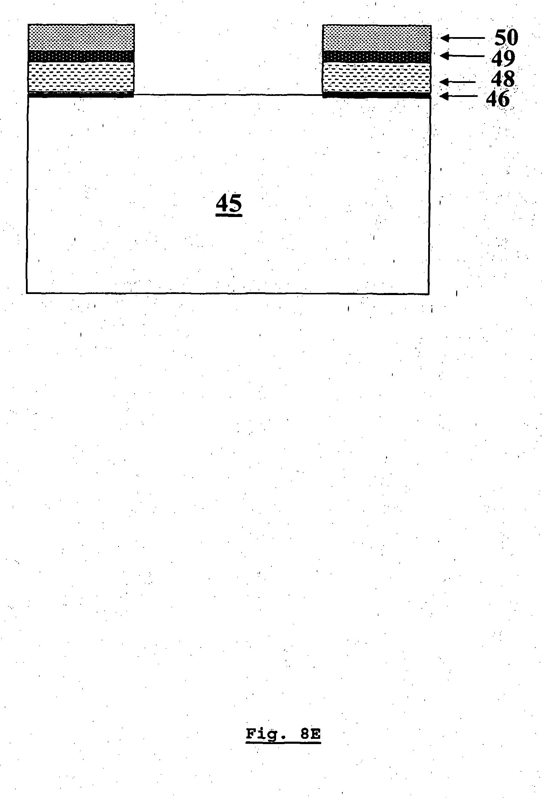

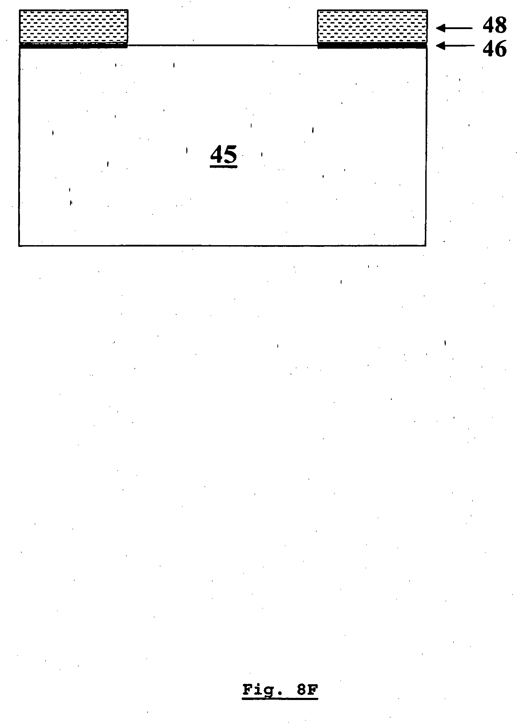

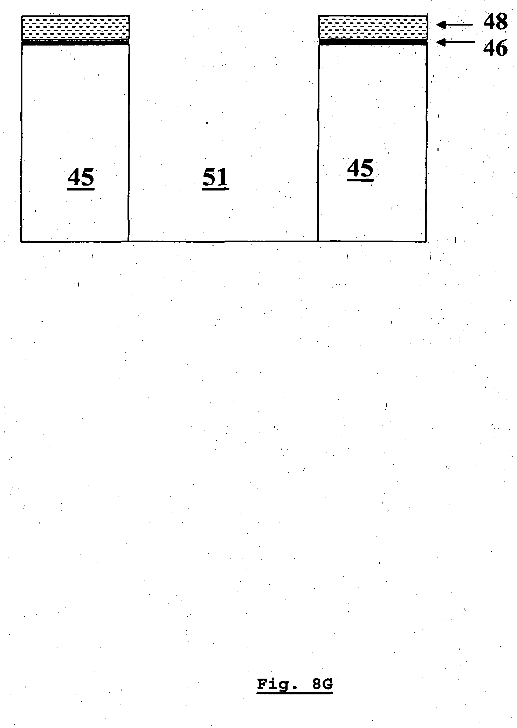

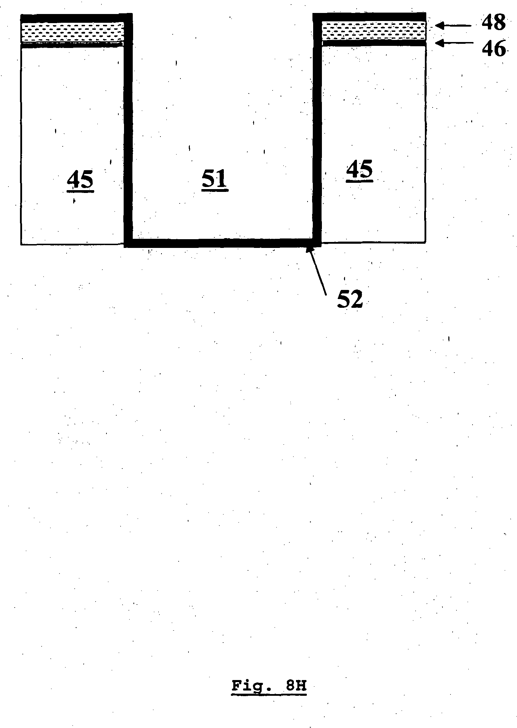

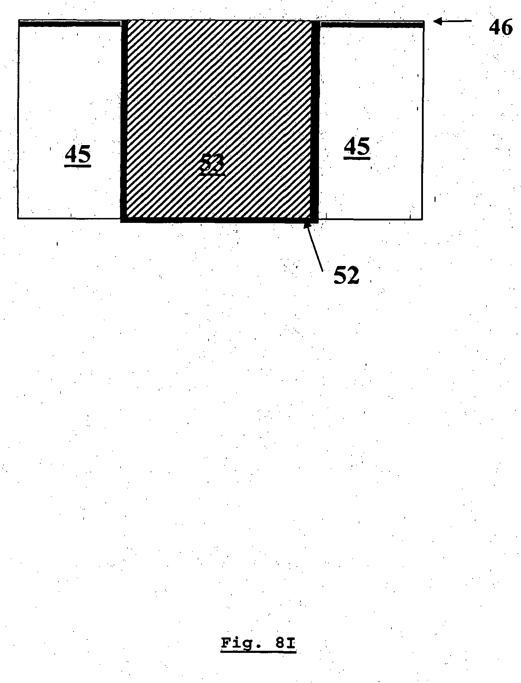

As an example not forming part of the present invention a method for patterning of single damascene structures is disclosed. The method is characterized in eliminating photoresist poisoning during single damascene patterning, also referred further to as trench patterning. The method is further characterized in avoiding or at least minimizing plasma damage to the dielectric material during trench etching. The method is schematically presented in Figures 8A-8I.

Preferably the starting point is a substrate with a dielectric material **45** on top of it.

The substrate is preferably a semiconductor substrate (e.g. Si wafer) and the dielectric material is preferably a low-k material and more preferably a silicon containing low-k material. Examples of these silicon containing low-k materials are CVD (Chemical Vapor Deposition) type low-k material such as (hydrogenated) silicon-oxy-carbide materials (SiCO(H) ) such as ^{®}Black Diamond and ^{®}Aurora.

An optional capping layer **46** is deposited on the upper surface of said dielectric layer **45,** this capping layer **46** may be formed of oxide-type materials such as TEOS-oxide and silane-oxide, or nitride-type materials such as SiC(N).

Subsequently a diffusion barrier layer **48** to eliminate photoresist poisoning' in further processing is deposited. The diffusion barrier layer **48** of the present invention is a hardmask layer, more preferred a metal hardmask layer. Examples of these metal hardmask layers are Ta(N), Ti(N), etc.

Imaging material(s) (or photosensitive layer(s)) is then deposited and a pattern to define the trench is transferred to the imaging material(s).

The imaging material(s) or stack of photosensitive layer(s) can consist of at least one photoresist layer **50** and optionally of at least one anti-reflective coating **49** (e.g. a Bottom Anti-Reflective Coating or BARC). Preferably, the imaging materials consist of at least one photoresist layer **50** and of at least one anti-reflective coating **49** (e.g. a Bottom Anti-Reflective Coating or BARC).

After the hardmask layer **48** and optionally also the capping layer **46** are opened, the imaging layer(s) is (are) removed by means of a stripping process (e.g. by means of a SF₆/O₂ dry strip plasma).

To etch the trench **51** in the dielectric material **45** an anisotropic etch process, which is, selective towards the hardmask is used. More specifically an etch process is used that is selective towards a metal hardmask layer **48,** which implies that almost no (metal) hardmask layer **48** is consumed during the etching process of the trench.

The etch chemistry of this etch process is further characterized such that it avoids plasma damage to the sidewalls of the trench 51 in the dielectric material **45.** The etch chemistry of this etch process is further characterized such that it avoids plasma damage to the dielectric material. Preferably this plasma is an oxygen-free plasma containing fluorocarbon compounds (CₓH_{y}F_{z} compounds), more preferred the CₓH_{y}F_{z} compound is C₄F₈. The etch plasma further contains nitrogen and may contain inert compounds such as argon, etc.

After trench patterning, a Copper diffusion barrier layer **52** is deposited in the trench to avoid migration of copper in the surrounding dielectric (low-k).

Common used copper diffusion barrier layers **52** such as Ta(N), Ti(N), WNC, etc., can be used here.

Subsequently the trench is electroplated with copper **53.**

The overburden of copper, the copper diffusion barrier layer and the remaining part of the (metal) hardmask layer is then removed by means of chemical mechanical polishing.

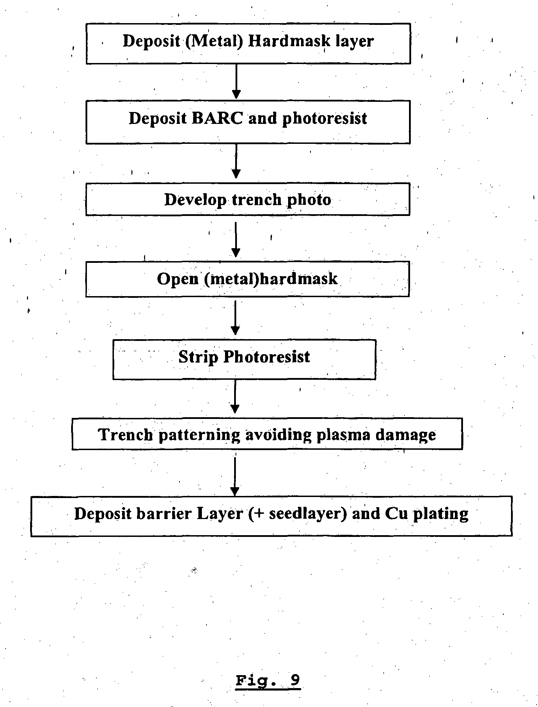

The above described process sequence is also schematically shown in Figure 9.

Alternatively to the method described above and also preferred, the etching of the trench opening **51** in the dielectric material **45** and removal of imaging material(s) (layer(s) **50** and if any **49,** respectively photoresist and BARC) are performed simultaneously. The anisotropic etch process used to perform this trench etching is also selective towards the (metal) hardmask **48** used. The etch chemistry of this etch process is further characterized such that it minimizes plasma damage to the sidewalls of the trench **51** in the dielectric material. Preferably this plasma is an oxygen-free plasma containing hydrogen. Other compounds such as inert compounds can be added to the plasma and preferably fluorocarbon compounds (CₓF_{y} compounds), more particularly CF₄, are added to this plasma.

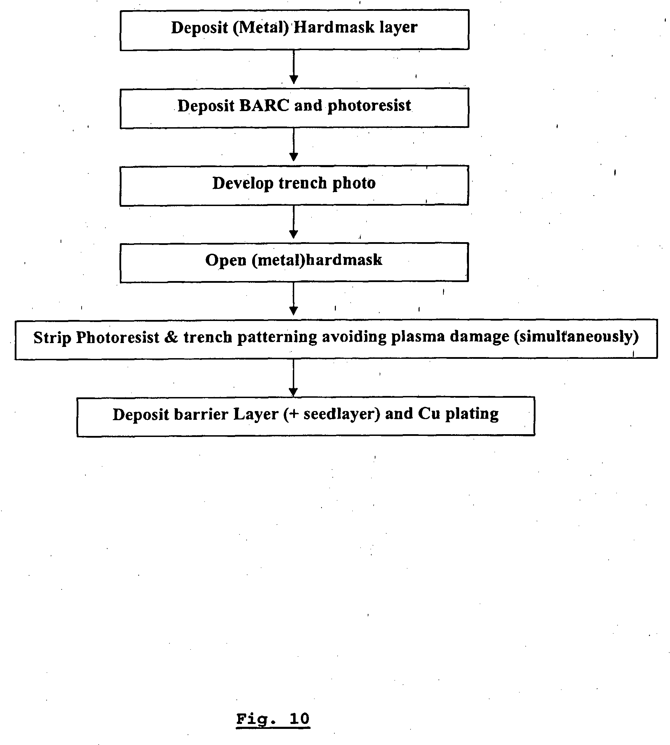

This alternative process flow is schematically shown in Figure 10.

### EXAMPLE

### Example 1: Processing a dual damascene structure on a substrate avoiding resist poisoning and reducing plasma damage to the side walls of the trench

The method, based on the process flow described in the invention is illustrated in this example.

The patterning of the trench (second hole) was done with a hardmask selective etch plasma comprising C₄F₈ without oxygen to avoid possible side wall damage of the trench during patterning.

The resist was stripped before the patterning of the trenches.

The dual damascene stack consisted of 30 nm SiC, 340 nm SiOC (k-value ∼ 3.0) and a 13 nm oxide cap. The via photo, with 100 nm target dimension, was exposed using a 20 nm thick BARC layer and 220 nm resist. Minium via pitch was 200 nm.

The via holes, including the SiC bottom layer opening, were etched as follows:
- 10 sec. BARC opening in CF₄/O₂
- 15 sec. via etching (step 1) in Ar/O₂/C₄F₈
- 20 sec. via etching (step 2) in Ar/N₂₀/C₄F₈/CH₂F₂
- 10 sec. resist strip in O₂/CF₄

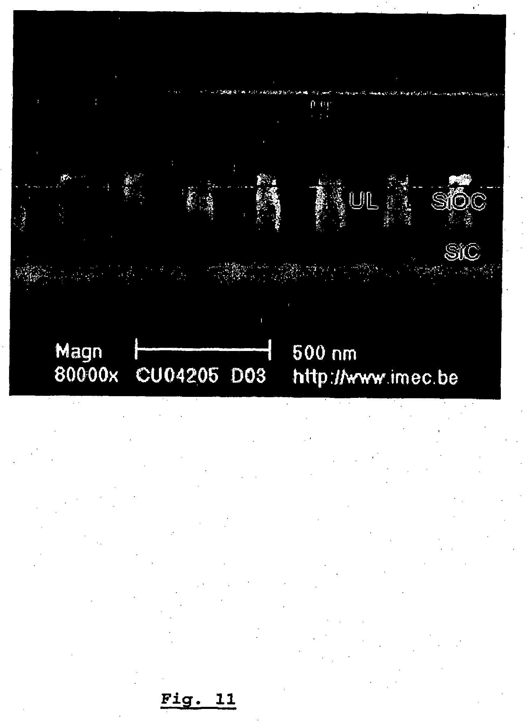

The vias were filled using 400 nm thick UL (bottom layer of the 193 nm version of the TIS2000 bilayer as commercially available from Fujifilm Electronic Materials). As can be concluded from Figure 11 good filling without voids was obtained.

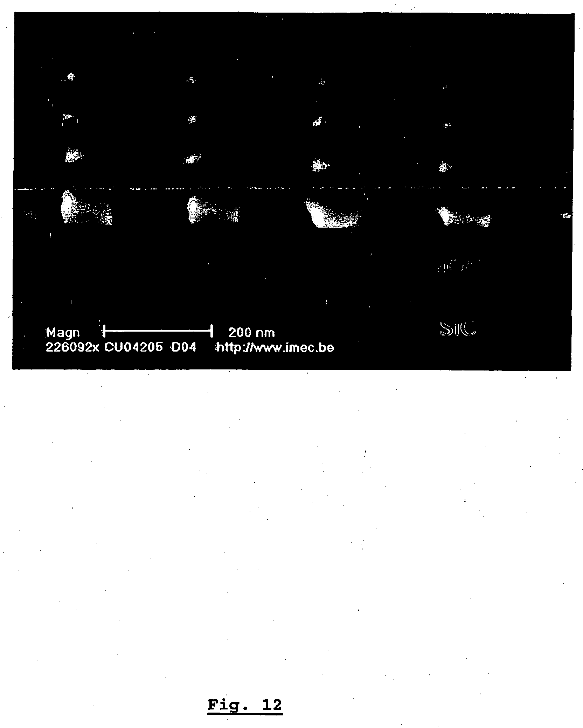

After filling, the vias were planarized using a 30" UL etchback step in a O₂/SO₂/CH₃F plasma. As shown in Figure 12 the remaining topography is limited to ∼50 nm on the most dense via structures, which are most critical.

For the TaN metal hardmask deposition on these UL-planarized structures, it is important to stay below the UL bake temperature (215 °C). Before deposition of a 50 nm TaN, the wafers were degassed at 150 °C for 10 min. The TaN deposition was done using 100 °C chuck temperature and the anticipated temperature increase due to Ar bombardment is expected to be less than 50 °C.

After TaN capping, the wafers were inspected in top view SEM and no delamination or other apparent problems were observed.

After planarization however sufficient topography was left on the 2 mm wide Athena alignment markers (ASML /1100 stepper was used for exposure), so that alignment of the trench photo on the (non-transparent) TaN hard mask was possible without an additional clear-out of the alignment marks.

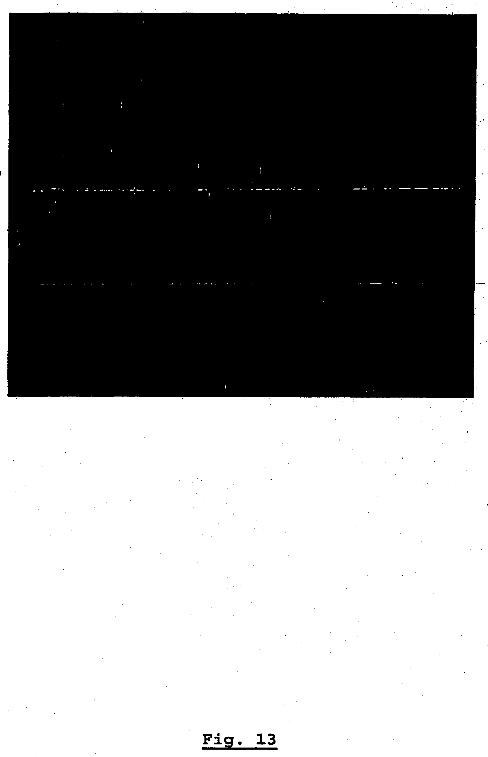

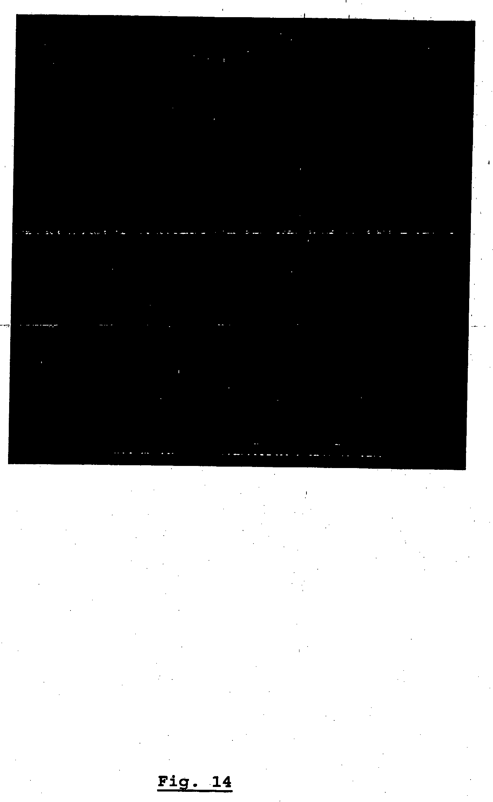

The trench photo on the metal hard mask was exposed using 35 nm thick BARC and 220 nm resist. The exposure was targeted to via links with 120/240 nm width/pitch as illustrated in Figure 13. The mean +3s trench-to-via misalignment error was ∼ 25 nm, which is well below the spec limit of 50 nm. The good alignment accuracy is further illustrated in Figure 14.

In order to minimize the low-k field and sidewall damage caused by (oxygen-containing) etch and strip plasmas, a metal-hard-mask-based trench patterning sequence was used, as follows:
- 60 sec. resist treatment in HBr
- 13 sec. BARC opening in HBr/O₂
- 35 sec. TaN metal hard mask opening in Cl₂
- 25 sec. resist strip in SF₆/O₂
- 40 sec. SiOC etching in Ar/C₄F₈/N₂ (oxygen-free!)

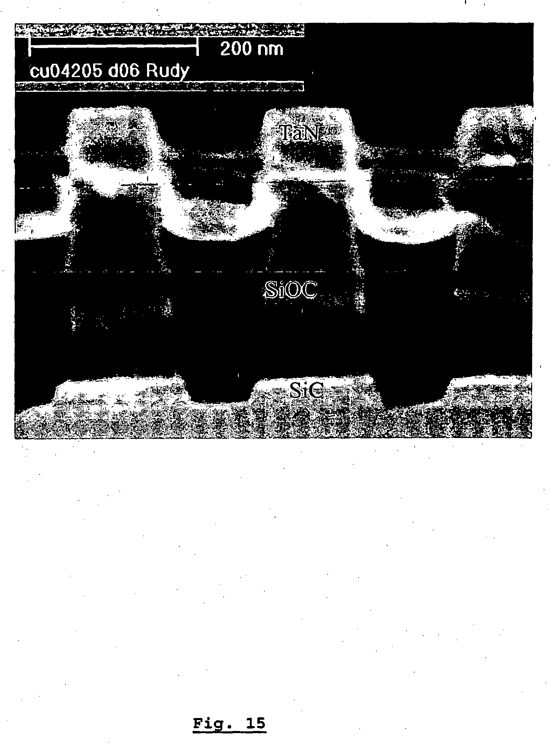

Figure 15 shows a SEM cross-section after metal hard mask opening and resist strip. About 75% of the via plugs remain filled with UL at this stage.

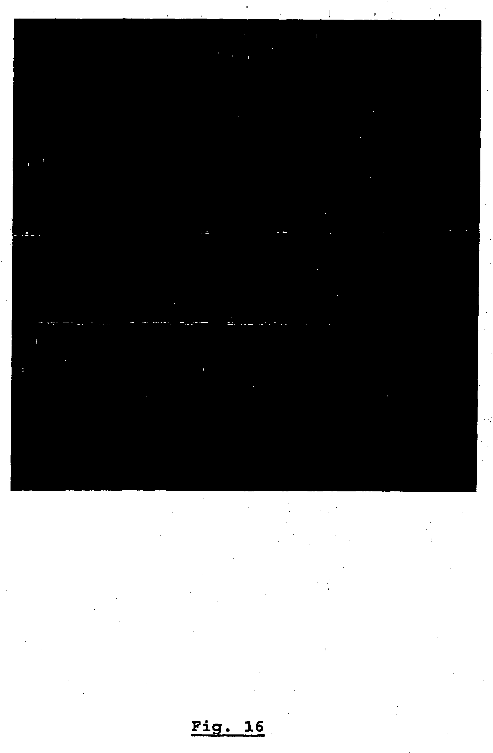

After completing the full dual damascene etch sequence as described above, top view SEM (as shown in Figure 16) was done showing well-behaving dual damascene profiles. The TaN cap will be removed during the CMP process.

In conclusion, an alternative dual damascene patterning approach was achieved with the following advantages:
- resist poisoning is avoided because the TaN hard mask blocks all amines;
- the trench etch is metal-hard-mask-based (selective), hereby avoiding damage of the low-k by the strip plasma, together with more freedom for the (oxygen-free) trench chemistry selection. In this way it was shown that the effective k-value after patterning is very close to the pristine one;
- a metal clear-out for the trench photo is avoided.

## Claims

1. A method for patterning a dual damascene structure comprising the steps of:
- depositing a dielectric layer (5) on a substrate,
- optionally depositing a capping layer (6) on said dielectric layer (5),
- etching a first hole (14) in said capping layer (6) and said dielectric layer (5),
- depositing a gap filling material (7) such that said first hole (14) is completely filled,
- removing part of the gap filling material (7) such that its level equals the level of said dielectric layer (5) or the level of said capping layer (6),
- depositing a metal hardmask layer (8) on said dielectric layer (5) or if present, on said capping layer (6),
- depositing imaging material(s) (9, 10), on said metal hardmask layer (8),
- forming at least one first pattern in said imaging material(s) (9, 10),
- transferring the pattern in said metal hardmask layer (8),
- removing said imaging material(s) (9, 10),
- removing said gap filling material (7), and
- etching a second hole (11) over said first hole (14) in said dielectric layer (5).

2. A method according to claim 1 wherein the first hole (14) is a via and the second hole (11) is a trench.

3. A method according to claim 1 or 2 wherein said substrate further comprises a patterned structure such as a single damascene interconnect structure.

4. A method according to any of claims 1 to 3 further comprising, before the step of depositing said dielectric layer (5), the step of depositing a dielectric barrier layer (4) upon said substrate.

5. A method according to any of claims 1 to 4 wherein the step of removing part of the gap filling material (7) is performed by means of a dry etch process or by means of chemical mechanical polishing.

6. A method according to any of claims 1 to 5 wherein said gap filling material (7) is removed before removing said imaging material(s) (9, 10).

7. A method according to any of claims 1 to 6 further comprising, after the step of etching said second hole (11), the step of depositing a copper diffusion barrier layer (12) and optionally a copper seed layer on the sidewalls of said first and second holes (14), (11) and the step of plating copper (13) in said first and second holes (14), (11).

8. A method according to claim 7 further comprising, after the step of plating copper (13), the step of removing the overburden of copper, the copper barrier layer, copper seed layer and the remaining metal hardmask layer that are underneath said overburden of copper, by means of chemical mechanical polishing.

9. A method according to any of claims 1 to 8 wherein said dielectric material (5) is a silicon containing dielectric material having pores.

10. A method according to any of claims 1 to 9 wherein said dielectric material (5) is a SiCO(H) material.

11. A method according to any of claims 1 to 10 wherein said gap filling material (7) consists of at least one organic material.

12. A method according to claim 11 wherein said organic material (7) is selected from the group consisting of Bottom Anti-Reflective Coating material, polyarylsulfones, polyhydroxystyrene based derivatives, polyimides, polyethers, in particular polyarylene ethers, polyarylenesulfides, polycarbonates, epoxies, epoxyacrylates, polyarylenes such as polyphenylenes, polyarylenevinylenes such as polyphenylenevinylenes, polyvinylcarbazole, cyclicolefins, and polyesters.

13. A method according to any of claims 1 to 12 wherein said metal hardmask layer (8) is selected from the group consisting of TaN, TiN, TaSiN, TiSiN, TiW, and WN layer.

14. A method according to any of claims 1 to 13 wherein said imaging material(s) comprises at least one photoresist layer (10) and optionally at least one Anti-Reflective Coating material (9) such as Bottom Anti-Reflective Coating material

15. A method according to any of claims 1 to 14 wherein the step of etching said second hole (11) uses an oxygen free plasma containing fluorocarbon compounds.

16. A method according to claim 15 wherein said fluorocarbon compounds are C₄F₈.

17. A method according to claim 15 or 16 wherein said oxygen free plasma further comprises nitrogen and/or inert compound(s) such as argon.

18. A method according to any of claims 1 to 14 wherein the steps of removing said imaging material(s) (9, 10) and of etching said second hole (11) in the dielectric layer (5) are performed in one step.

19. A method according to any of claims 1 to 14 wherein the steps of removing said imaging material(s) (9, 10), of removing said gap filling material (7) and of etching said second hole (11) are performed in one step.

20. A method according to claim 18 or 19 wherein the steps of simultaneously removing said imaging material(s) (9, 10), possibly removing said gap filling material (7) and etching said second hole (11) use an oxygen free plasma containing hydrogen.

21. A method according to claim 20 wherein said oxygen free plasma containing hydrogen further comprises fluorocarbon compounds.

22. A method according to claim 21, wherein said fluorocarbon compounds are CF₄.

23. A method according to claim 21 or 22 wherein said oxygen free plasma containing hydrogen further comprises nitrogen.

## Patentansprüche

1. Ein Verfahren zum Strukturieren eines Dual-Damascene-Gefüges, folgende Schritte umfassend:
- Abscheiden einer dielektrischen Schicht (5) auf einem Substrat,
- optionales Abscheiden einer Deckschicht (6) auf der dielektrischen Schicht (5),
- Ätzen einer ersten Öffnung (14) in die Deckschicht (6) und die dielektrische Schicht (5),
- Abscheiden eines offene Stellen füllenden Materials (7) so, dass die erste Öffnung (14) vollständig gefüllt ist,
- Entfernen eines Teils des offene Stellen füllenden Materials (7) so, dass dessen Niveau dem Niveau der dielektrischen Schicht (5) oder dem Niveau der Deckschicht (6) gleicht,
- Abscheiden einer Metallhartmaskenschicht (8) auf der dielektrischen Schicht (5) oder, wenn vorhanden, auf der Deckschicht (6),
- Abscheiden von abbildendem Material (9, 10), auf der Metallhartmaskenschicht (8),
- Bilden mindestens einer ersten Struktur im abbildenden Material (9, 10),
- Übertragen der Struktur in die Metallhartmaskenschicht (8),
- Entfernen des abbildenden Materials (9, 10),
- Entfernen des offene Stellen füllenden Materials (7), und
- Ätzen einer zweiten Öffnung (11) über der ersten Öffnung (14) in die dielektrische Schicht (5).

2. Ein Verfahren nach Anspruch 1 wobei die erste Öffnung (14) eine Durchkontaktierung und die zweite Öffnung (11) ein Graben ist.

3. Ein Verfahren nach Anspruch 1 oder 2 wobei das Substrat ferner ein strukturiertes Gefüge umfasst, wie beispielsweise ein einzelnes Damascene-Verbindungsgefüge.

4. Ein Verfahren nach einem der Ansprüche 1 bis 3 vor dem Schritt des Abscheidens der dielektrischen Schicht (5) ferner den Schritt des Abscheidens einer dielektrischen Sperrschicht (4) auf dem Substrat umfassend.

5. Ein Verfahren nach einem der Ansprüche 1 bis 4 wobei der Schritt des Entfernens eines Teils des offene Stellen füllenden Materials (7) mittels eines Trockenätzprozesses oder mittels chemisch-mechanischen Polierens ausgeführt wird.

6. Ein Verfahren nach einem der Ansprüche 1 bis 5 wobei das offene Stellen füllende Material (7) vor dem Entfernen des abbildenden Materials (9, 10) entfernt wird.

7. Ein Verfahren nach einem der Ansprüche 1 bis 6 nach dem Schritt des Ätzens der zweiten Öffnung (11) ferner den Schritt des Abscheidens einer Kupferdiffusions-Sperrschicht (12) und optional einer Kupfersaatschicht auf den Seitenwänden der ersten und der zweiten Öffnung (14), (11) und den Schritt des Verkupferns (13) in der ersten und der zweiten Öffnung (14), (11) umfassend.

8. Ein Verfahren nach Anspruch 7 nach dem Schritt des Verkupferns (13) ferner den Schritt des Entfernens des Cu-Overburden, der Kupfersperrschicht, der Kupfersaatschicht und der restlichen Metallhartmaskenschicht die unter dem CU-Overburden liegen, mittels chemisch-mechanischen Polierens umfassend.

9. Ein Verfahren nach einem der Ansprüche 1 bis 8 wobei das dielektrische Material (5) ein siliziumhaltiges dielektrisches Material mit Poren ist.

10. Ein Verfahren nach einem der Ansprüche 1 bis 9 wobei das dielektrische Material (5) ein SiCO(H)-Material ist.

11. Ein Verfahren nach einem der Ansprüche 1 bis 10 wobei das offene Stellen füllende Material (7) aus mindestens einem organischen Material besteht.

12. Ein Verfahren nach Anspruch 11 wobei das organische Material (7) aus der Gruppe ausgewählt wird, die aus Antireflex-Unterschicht-Material, Polyarylsulfonen, Polyhydroxystyrol basierte Derivate, Polyimiden, Polyethern, insbesondere Polyarylenethern, Polyarylensulfiden, Polycarbonaten, Epoxiden, Epoxyacrylaten, Polyarylenen wie beispielsweise Polyphenylenen, Polyarylenvinylenen wie beispielsweise Polyphenylenvinylenen, Polyvinylcarbazol, Cycloolefinen, und Polyestern besteht.

13. Ein Verfahren nach einem der Ansprüche 1 bis 12 wobei die Metallhartmaskenschicht (8) aus der Gruppe ausgewählt wird, die aus einer TaN-, TiN-, TaSiN-, TiSiN-, TiW-, und WN-Schicht besteht.

14. Ein Verfahren nach einem der Ansprüche 1 bis 13 wobei das abbildende Material mindestens eine Fotoresistschicht (10) und optional mindestens eine Antireflexschicht-Material (9), wie beispielsweise eine Antireflex-Unterschicht-Material, umfasst.

15. Ein Verfahren nach einem der Ansprüche 1 bis 14 wobei der Schritt des Ätzens der zweiten Öffnung (11) einen sauerstofffreien Plasma, das Fluorkohlenstoffverbindungen enthält, verwendet.

16. Ein Verfahren nach Anspruch 15 wobei die Fluorkohlenstoffverbindungen C₄F₈ sind.

17. Ein Verfahren nach Anspruch 15 oder 16 wobei das sauerstofffreie Plasma ferner Stickstoff und/oder inerte Verbindung(en), wie beispielsweise Argon, umfasst.

18. Ein Verfahren nach einem der Ansprüche 1 bis 14 wobei die Schritte des Entfernens des abbildenden Materials (9, 10) und des Ätzens der zweiten Öffnung (11) in die dielektrischen Schicht (5) in einem Schritt ausgeführt werden.

19. Ein Verfahren nach einem der Ansprüche 1 bis 14 wobei die Schritte des Entfernens des abbildenden Materials (9, 10), des Entfernens des offene Stellen füllenden Materials (7) und des Ätzens der zweiten Öffnung (11) in einem Schritt ausgeführt werden.

20. Ein Verfahren nach Anspruch 18 oder 19 wobei die Schritte des gleichzeitigen Entfernens des abbildenden Materials (9, 10), möglichst des Entfernens des offene Stellen füllenden Materials (7) und des Ätzens der zweiten Öffnung (11) einen sauerstofffreien Plasma, das Wasserstoff enthält, verwenden.

21. Ein Verfahren nach Anspruch 20 wobei der sauerstofffreie Plasma, das Wasserstoff enthält, ferner Fluorkohlenstoffverbindungen umfasst.

22. Ein Verfahren nach Anspruch 21 wobei die Kohlenwasserstoffverbindungen CF₄ sind.

23. Ein Verfahren nach Anspruch 21 oder 22 wobei der sauerstofffreie Plasma, das Wasserstoff enthält, ferner Stickstoff umfasst.

## Revendications

1. Procédé pour dessiner une structure damasquinée double comprenant les étapes :
- de dépôt d'une couche diélectrique (5) sur un substrat,
- facultativement, de dépôt d'une couche d'encapsulation (6) sur ladite couche diélectrique (5),
- de gravure d'un premier trou (14) dans ladite couche d'encapsulation (6) et dans ladite couche diélectrique (5),
- de dépôt d'un matériau de remplissage d'espace (7) de sorte que ledit premier trou (14) soit complètement rempli,
- de retrait d'une partie du matériau de remplissage d'espace (7) de sorte que son niveau soit égal au niveau de ladite couche diélectrique (5) ou au niveau de ladite couche d'encapsulation (6),
- de dépôt d'une couche de masque rigide métallique (8) sur ladite couche diélectrique (5) ou, si présente, sur ladite couche d'encapsulation (6),
- de dépôt d'un matériau de formation d'image (9, 10) sur ladite couche de masque rigide métallique (8),
- de formation d'au moins un premier dessin dans ledit ou lesdits matériaux de formation d'image (9, 10),
- de transfert du dessin dans ladite couche de masque rigide métallique (8),
- de retrait dudit ou desdits matériaux de formation d'image (9, 10),
- de retrait dudit matériau de remplissage d'espace (7), et
- de gravure d'un deuxième trou (11) au-dessus dudit premier trou (14) dans ladite couche diélectrique (5).

2. Procédé selon la revendication 1, dans lequel le premier trou (14) est un trou de traversée et le deuxième trou (11) est une tranchée.

3. Procédé selon la revendication 1 ou 2, dans lequel ledit substrat comprend en outre une structure dessinée telle qu'une structure d'interconnexion damasquinée unique.

4. Procédé selon l'une quelconque des revendications 1 à 3, comprenant en outre, avant l'étape de dépôt de ladite couche diélectrique (5), l'étape de dépôt d'une couche de barrière diélectrique (4) sur ledit substrat.

5. Procédé selon l'une quelconque des revendications 1 à 4, dans lequel l'étape de retrait d'une partie du matériau de remplissage d'espace (7) est effectuée au moyen d'un processus de gravure à sec ou au moyen d'un polissage chimico-mécanique.

6. Procédé selon l'une quelconque des revendications 1 à 5, dans lequel ledit matériau de remplissage d'espace (7) est retiré avant le retrait dudit ou desdits matériaux de formation d'image (9, 10).

7. Procédé selon l'une quelconque des revendications 1 à 6, comprenant en outre, après l'étape de gravure dudit deuxième trou (11), l'étape de dépôt d'une couche de barrière à la diffusion du cuivre (12) et, facultativement, d'une couche germinale de cuivre sur les parois latérales desdits premier et deuxième trous (14), (11) et l'étape de dépôt de cuivre (13) dans lesdits premier et deuxième trous (14), (11).

8. Procédé selon la revendication 7, comprenant en outre, après l'étape de dépôt de cuivre (13), l'étape de retrait de la surcharge de cuivre, de la couche de barrière au cuivre, de la couche germinale de cuivre et de la couche de masque rigide métallique restante qui sont au-dessous de ladite surcharge de cuivre, au moyen d'un polissage chimico-mécanique.

9. Procédé selon l'une quelconque des revendications 1 à 8, dans lequel ledit matériau diélectrique (5) est un matériau diélectrique contenant du silicium comportant des pores.

10. Procédé selon l'une quelconque des revendications 1 à 9, dans lequel ledit matériau diélectrique (5) est du SiCO(H).

11. Procédé selon l'une quelconque des revendications 1 à 10, dans lequel ledit matériau de remplissage d'espace (7) consiste en au moins un matériau organique.

12. Procédé selon la revendication 11, dans lequel ledit matériau organique (7) est sélectionné dans le groupe consistant en un matériau de revêtement anti-réflexion de fond, des polyarylsulfones, des dérivés à base de polyhydroxystyrène, des polyimides, des polyéthers, en particulier des éthers polyarylènes, des polyarylènesulfides, des polycarbonates, des époxy, des époxyacrylates, des polyarylènes tels que des polyphénylènes, des polyarylènevinylènes tels que des polyphénylènevinylènes, le polyvinylcarbazole, des oléfines cycliques, et des polyesters.

13. Procédé selon l'une quelconque des revendications 1 à 12, dans lequel ladite couche de masque rigide métallique (8) est sélectionnée dans le groupe consistant en les couches de TaN, de TiN, de TaSiN, de TiSiN, de TiW, et de WN.

14. Procédé selon l'une quelconque des revendications 1 à 13, dans lequel ledit ou lesdits matériaux de formation d'image comprennent au moins une couche de photorésine (10) et, facultativement, au moins un matériau de revêtement anti-réflexion (9) tel qu'un matériau de revêtement anti-réflexion de fond.

15. Procédé selon l'une quelconque des revendications 1 à 14, dans lequel l'étape de gravure dudit deuxième trou (11) utilise un plasma exempt d'oxygène contenant des composés fluorocarbonés.

16. Procédé selon la revendication 15, dans lequel lesdits composés fluorocarbonés sont le C₄F₈.

17. Procédé selon la revendication 15 ou 16, dans lequel ledit plasma exempt d'oxygène comprend en outre de l'azote et/ou un ou des composés inertes tels que l'argon.

18. Procédé selon l'une quelconque des revendications 1 à 14, dans lequel les étapes de retrait dudit ou desdits matériaux de formation d'image (9, 10) et de gravure dudit deuxième trou (11) dans la couche diélectrique (5) sont effectuées en une seule étape.

19. Procédé selon l'une quelconque des revendications 1 à 14, dans lequel les étapes de retrait dudit ou desdits matériaux de formation d'image (9, 10), de retrait dudit matériau de remplissage d'espace (7) et de gravure dudit deuxième trou (11) sont effectuées en une étape.

20. Procédé selon la revendication 18 ou 19, dans lequel les étapes de retrait simultané dudit ou desdits matériaux de formation d'image (9, 10), de retrait éventuel dudit matériau de remplissage d'espace (7) et de gravure dudit deuxième trou (11) utilisent un plasma exempt d'oxygène contenant de l'hydrogène.

21. Procédé selon la revendication 20, dans lequel ledit plasma exempt d'oxygène contenant de l'hydrogène comprend en outre des composés fluorocarbonés.

22. Procédé selon la revendication 21, dans lequel lesdits composés fluorocarbonés sont le CF₄.

23. Procédé selon la revendication 21 ou 22, dans lequel ledit plasma exempt d'oxygène contenant de l'hydrogène comprend en outre de l'azote.
